# EUROPEAN PATENT APPLICATION

(11) **EP 4 568 459 A1**
(43) Date of publication of application: **11.06.2025**
(21) Application number: 24213567.1
(22) Date of filing: 18.11.2024
(51) Int. Cl.: H10K 59/131, G09G 3/3233, H10K 59/123

(54) **DISPLAY PANEL**

(30) Priority: 27.11.2023 KR 20230166461
(71) Applicant: Samsung Display Co., Ltd., Gyeonggi-do (KR)
(72) Inventor: KIM, Sunho, Yongin-si (KR); KO, Yoomin, Yongin-si (KR); KIM, Hyewon, Yongin-si (KR); PARK, Juchan, Yongin-si (KR); LEE, Pilsuk, Yongin-si (KR); CHOI, Chung Sock, Yongin-si (KR); HONG, Sungjin, Yongin-si (KR)
(74) Representative: Marks & Clerk LLP

(57) **Abstract**

A display panel includes: a driving element layer including: a first pixel driver including a first conductive pattern; and a second pixel driver including a second conductive pattern; a light emitting element on the driving element layer, and including a first electrode, an intermediate layer on the first electrode, and a second electrode on the intermediate layer; a connection electrode on the driving element layer, and electrically connected with the first pixel driver and the second electrode; and a metal layer between the second conductive pattern and the connection electrode in a cross-sectional view.

## Description

### BACKGROUND

### 1. Field

Aspects of embodiments of the present disclosure relate to a display panel, and more particularly, to a display panel having reduced afterimage.

### 2. Description of the Related Art

A multi-media electronic device, such as a television, a mobile phone, a tablet, a computer, a navigator, a game player, or the like, is provided with a display panel for displaying an image. The display panel includes light emitting elements, and circuits for controlling the light emitting elements. The light emitting elements included in the display panel emit light to generate an image according to voltages applied from the circuits. In order to improve a reliability of the display panel, improved connections between the light emitting elements and the circuits may be desired.

The above information disclosed in this Background section is for enhancement of understanding of the background of the present disclosure, and therefore, it may contain information that does not constitute prior art.

### SUMMARY

One or more embodiments of the present disclosure may be directed to a display panel having reduced afterimage.

According to one or more embodiments of the present disclosure, a display panel includes: a driving element layer including: a first pixel driver including a first conductive pattern; and a second pixel driver including a second conductive pattern; a light emitting element on the driving element layer, and including a first electrode, an intermediate layer on the first electrode, and a second electrode on the intermediate layer; a connection electrode on the driving element layer, and electrically connected with the first pixel driver and the second electrode; and a metal layer between the second conductive pattern and the connection electrode in a cross-sectional view.

In an embodiment, the first conductive pattern may include: a (1-1)-th pattern; and a (2-1)-th pattern electrically connected with the connection electrode.

In an embodiment, the second conductive pattern may include a (1-2)-th pattern and a (2-2)-th pattern.

In an embodiment, the (1-2)-th pattern and the (2-2)-th pattern may overlap with the metal layer in a plan view.

In an embodiment, the (1-2)-th pattern and the (2-2)-th pattern may overlap with the connection electrode in a plan view.

In an embodiment, the (1-1)-th pattern and the (1-2)-th pattern may include source electrode patterns.

In an embodiment, the (2-1)-th pattern and the (2-2)-th pattern may include drain electrode patterns.

In an embodiment, the display panel may further include an intermediate connection electrode electrically connecting the first pixel driver and the connection electrode to each other.

In an embodiment, the metal layer may include a same material as that of the intermediate connection electrode, and may be located at a same layer as that of the intermediate connection electrode.

In an embodiment, the metal layer may include a same material as that of the first electrode, and may be connected to the first electrode.

In an embodiment, the display panel may further include a pixel definition layer on the driving element layer, and having an emission opening therethrough exposing at least a portion of the first electrode. The connection electrode may have a ring shape surrounding the emission opening.

In an embodiment, a bottom surface of the second electrode may contact a top surface of the connection electrode.

In an embodiment, the display panel may further include a separator on the connection electrode, and the second electrode and the connection electrode may be connected to each other at an area adjacent to the separator.

In an embodiment, the connection electrode may include: a first edge; and a second edge surrounding the first edge and overlapping with the separator.

According to one or more embodiments of the present disclosure, a display panel includes: a driving element layer including a pixel driver including a conductive pattern; a light emitting element on the driving element layer, and including a first electrode, an intermediate layer on the first electrode, and a second electrode on the intermediate layer; a connection electrode on the driving element layer, and electrically connected with the pixel driver and the second electrode; and a metal layer overlapping with the connection electrode and the conductive pattern in a plan view.

In an embodiment, the conductive pattern may include: a first pattern; and a second pattern electrically connected with the connection electrode.

In an embodiment, the first pattern may include a source electrode pattern, and the second pattern may include a drain electrode pattern.

In an embodiment, the display panel may further include an intermediate connection electrode electrically connecting the pixel driver and the connection electrode to each other.

In an embodiment, the metal layer may include a same material as that of the intermediate connection electrode, and may be located on a same layer as that of the intermediate connection electrode.

In an embodiment, the metal layer may include a same material as that of the first electrode, and may be connected to the first electrode.

At least some of the above and other features of the invention are set out in the claims.

However, the present disclosure is not limited to the above aspects and features, and the above and other aspects and features of the present disclosure will be set forth, in part, in the detailed description that follows with reference to the drawings, and in part, may be apparent therefrom, or may be learned by practicing one or more of the presented embodiments of the present disclosure.

### BRIEF DESCRIPTION OF THE DRAWINGS

The above and other aspects and features of the present disclosure will be more clearly understood from the following detailed description of the illustrative, nonlimiting embodiments with reference to the accompanying drawings, in which:
FIG. 1 is a block diagram of a display device according to an embodiment of the present disclosure;
FIGS. 2A-2C are equivalent circuit diagrams of a pixel according to one or more embodiments of the present disclosure;
FIGS. 3A and 3B are plan views of a display panel according to one or more embodiments of the present disclosure.
FIGS. 4A-4D are enlarged plan views of partial areas of a display panel according to one or more embodiments of the present disclosure;
FIG. 5 is a cross-sectional view of a display panel according to an embodiment of the present disclosure;
FIG. 6 is an enlarged plan view of a partial area of a display panel according to an embodiment of the present disclosure;
FIG. 7 is a cross-sectional view of a display panel according to an embodiment of the present disclosure;
FIG. 8 is a cross-sectional view of a display panel according to an embodiment of the present disclosure;
FIG. 9 is an enlarged cross-sectional view of a partial area of a display panel according to an embodiment of the present disclosure; and
FIG. 10 is a cross-sectional view of a display panel according to an embodiment of the present disclosure.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present disclosure in its entirety, each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

As used herein, various terms including "part" or "unit" may refer to a software component or a hardware component performing specific functions. The hardware component may include, for example, a field-programmable gate array (FPGA) or an application-specific integrated circuit (ASIC). The software component may refer to executable code and/or data used by the executable code in an addressable recording medium. Accordingly, software components may be, for example, object-oriented software components, class components, and task components, and may include processors, functions, attributes, procedures, subroutines, program code segments, drivers, firmware, microcode, circuits, data, databases, data structures, tables, arrays, variables, and/or the like.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

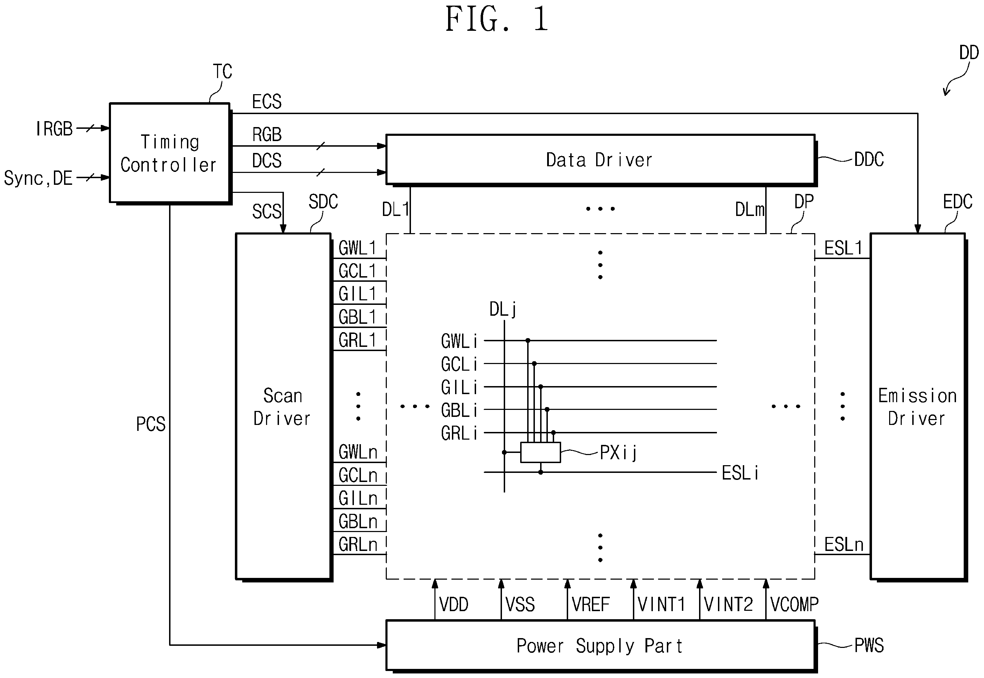

FIG. 1 is a block diagram of a display device DD according to an embodiment of the present disclosure.

Referring to FIG. 1, the display device DD may include a display panel DP, panel drivers SDC, EDC, and DDC, a power supply part (e.g., a power supply or a power source) PWS, and a timing controller TC. In the embodiment, the display panel DP may be described in more detail in the context of an emissive display panel. The emissive display panel may include an organic light emitting display panel, an inorganic light emitting display panel, or a quantum dot light emitting display panel. In an embodiment, the organic light emitting display panel may be described in more detail below as a representative example of the display panel DP. The panel drivers SDC, EDC, and DDC may include a scan driver SDC, an emission driver EDC, and a data driver DDC.

The display panel DP may include scan lines GWL1 to GWLn, GCL1 to GCLn, GIL1 to GILn, GBL1 to GBLn, and GRL1 to GRLn, emission lines ESL1 to ESLn, and data lines DL1 to DLm, where n and m are integers greater than 1. The display panel DP may include a plurality of pixels connected to the scan lines GWL1 to GWLn, GCL1 to GCLn, GIL1 to GILn, GBL1 to GBLn, GRL1 to GRLn, the emission lines ESL1 to ESLn, and the data lines DL1 to DLm.

For example, a pixel PXij (where i is greater than or equal to 1 and less than or equal to n, and j is greater than or equal to 1 and less than or equal to m) positioned at an i-th horizontal line (e.g., an i-th pixel row) and a j-th vertical line (e.g., a j-th pixel column) may be connected to an i-th first scan line (e.g., a write scan line GWLi), an i-th second scan line (e.g., a compensation scan line GCLi), an i-th third scan line (e.g., a first initialization scan line GILi), an i-th fourth scan line (e.g., a second initialization scan line GBLi), an i-th fifth scan line (e.g., a reset scan line GRLi), a j-th data line DLj, and an i-th emission line ESLi.

The pixel PXij may include at least one light emitting element, a plurality of transistors, and at least one capacitor. The pixel PXij may receive, through the power supply part PWS, a first power supply voltage VDD, a second power supply voltage VSS, a third power supply voltage (e.g., a reference voltage) VREF, a fourth power supply voltage (e.g., a first initialization voltage) VINT1, a fifth power supply voltage (e.g., a second initialization voltage) VINT2, and a sixth power supply voltage (e.g., a compensation voltage) VCOMP.

Values (e.g., voltage values) of the first power supply voltage VDD and second power supply voltage VSS may be determined (e.g., may be set) so that a current flows through the light emitting element to emit light. For example, the first power supply voltage VDD may be higher than the second power supply voltage VSS.

The third power supply voltage VREF may be used to initialize a gate of a driving transistor included in the pixel PXij. The third power supply voltage VREF may be used to implement a prescribed gradation using a difference from a voltage of a data signal. As such, the third power supply voltage VREF may have a prescribed voltage within a suitable voltage range of the data signal.

The fourth power supply voltage VINT1 may be used to initialize a capacitor included in the pixel PXij. The fourth power supply voltage VINT1 may be lower than the third power supply voltage VREF. For example, the fourth power supply voltage VINT1 may have a voltage lower than that of a difference between the third power supply voltage VREF and a threshold voltage of the driving transistor. However, the present disclosure is not limited thereto.

The fifth power supply voltage VINT2 may be used to initialize a cathode of the light emitting element included in the pixel PXij. The fifth power supply voltage VINT2 may have a voltage lower than that of the first power supply voltage VDD or the fourth power supply voltage VINT1, or may have a voltage similar to or the same as that of the third power supply voltage VREF, but the present disclosure is not limited thereto. The fifth power supply voltage VINT2 may have a voltage similar to or the same as that of the first power supply voltage VDD.

The sixth power supply voltage VCOMP may supply a prescribed current to the driving transistor when the threshold voltage of the driving transistor is compensated for.

In FIG. 1, the first to sixth power supply voltages VDD, VSS, VREF, VINT1, VINT2, and VCOMP are shown as being supplied from the power supply part PWS, but the present disclosure is not limited thereto. For example, the first power supply voltage VDD and the second power supply voltage VSS may be supplied regardless of the structure of the pixel PXij, and at least one of the third power supply voltage VREF, the fourth power supply voltage VINT1, the fifth power supply voltage VINT2, or the sixth power supply voltage VCOMP may not be supplied in correspondence to the structure of the pixel PXij.

In an embodiment of the present disclosure, the signal lines connected to the pixel PXij may be designed in various suitable ways in correspondence to the circuit structure of the pixel PXij.

The scan driver SDC may receive a first control signal SCS from the timing controller TC, and may supply, on the basis of the first control signal SCS, respective scan signals to the first scan lines GWL1 to GWLn, the second scan lines GCL1 to GCLn, the third scan lines GIL1 to GILn, the fourth scan lines GBL1 to GBLn, or the fifth scan lines GRL1 to GRLn.

Each of the scan signals may have a voltage by which a transistor supplied with the scan signal may be turned on. For example, the scan signal supplied to a P-type transistor may have a logic low level, and the scan signal supplied to an N-type transistor may have a logic high level. As used herein, the phrase "the scan signal is supplied" may be understood as the scan signal that is supplied as having a logic level to turn on the transistor controlled by the scan signal (e.g., a turn-on level).

For convenience of illustration, FIG. 1 shows the scan driver SDC as having a single component, but the present disclosure is not limited thereto. According to an embodiment, a plurality of scan drivers may be included to supply the scan signals to the first scan lines GWL1 to GWLn, the second scan lines GCL1 to GCLn, the third scan lines GIL1 to GILn, the fourth scan lines GBL1 to GBLn, or the fifth scan lines GRL1 to GRLn.

The emission driver EDC may output emission control signals to the plurality of emission lines ESL1 to ESLn on the basis of a second control signal ECS. For example, the emission control signals may be sequentially supplied to the emission lines ESL1 to ESLn.

The transistors connected to the emission lines ESL1 to ESLn according to an embodiment of the present disclosure may be constituted of N-type transistors. The emission signal supplied to the emission lines ESL1 to ESLn may have a gate-off voltage. The transistors configured to receive the emission signals may be turned off when the emission signal is supplied, and may be in a turned-on state otherwise.

The second control signal ECS may include an emission start signal and clock signals. The emission driver EDC may be implemented with a shift register configured to sequentially shift an emission start signal of a pulse type using the clock signals to sequentially generate and output the emission signals having a pulse type.

The data driver DDC may receive a third control signal DCS and image data RGB from the timing controller TC. The data driver DDC may convert the digital image data RGB into an analog data signal (e.g., a data signal). The emission driver DDC may supply the data signal to the data lines DL1 to DLm in response to the third control signal DCS.

The third control signal DCS may include a data enable signal, a horizontal start signal, a data clock signal, or the like for instructing an output of a valid data signal. For example, the data driver DDC may include a shift register to shift the horizontal start signal in synchronization with the data clock signal to generate a sampling signal, a latch to latch the image data RGB in response to the sampling signal, a digital-to-analog converter (e.g., a decoder) to convert the latched image data (e.g., the digital data) to analog data signals, and buffers (e.g., amplifiers) to output the data signals to the data lines DL1 to DLm.

The power supply part PWS may supply, to the display panel DP, the first power supply voltage VDD, the second power supply voltage VSS, or the third power supply voltage VREF for driving the pixel PXij. In addition, the power supply part PWS may supply, to the display panel DP, at least one of the fourth power supply voltage VINT1, the fifth power supply voltage VINT2, or the sixth power supply voltage VCOMP.

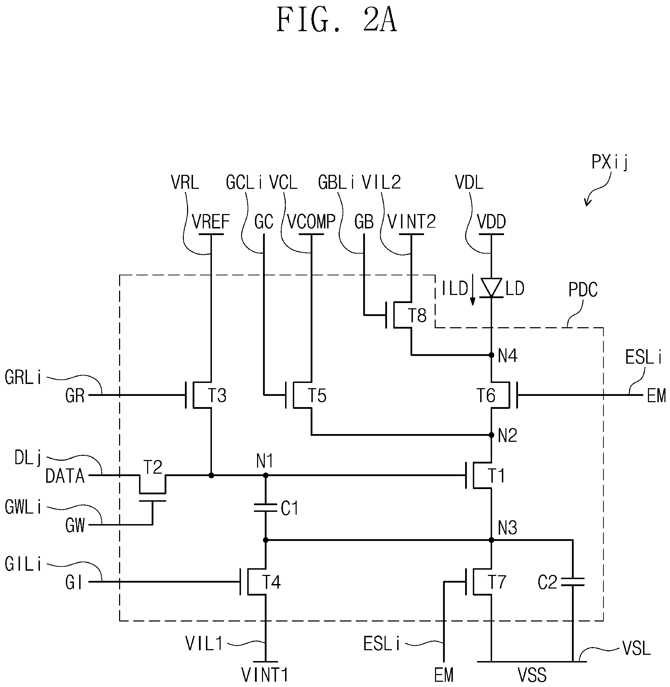

For example, the power supply part PWS may supply, to the display panel DP, the first power supply voltage VDD, the second power supply voltage VSS, the third power supply voltage VREF, the fourth power supply voltage VINT1, the fifth power supply voltage VINT2, or the sixth power supply voltage VCOMP via a first power line VDL (e.g., see FIG. 2A), a second power line VSL, a third power line (e.g., a reference voltage line) VRL, a fourth power line (e.g., a first initialization voltage line) VIL1, a fifth power line (e.g., a second initialization voltage line) VIL2, and a sixth power line (e.g., a voltage compensation line) VCL.

The power supply part PWS may be implemented as a power management integrated circuit, but the present disclosure is not limited thereto.

The timing controller TC may generate the first control signal SCS, the second control signal ECS, the third control signal DCS, and a fourth control signal PCS on the basis of input image data IRGB, a synchronization signal Sync (e.g., a vertical sync signal, a horizontal sync signal, and the like), the data enable signal DE, the clock signal, or the like. The first control signal SCS may be supplied to the scan driver SDC, the second control signal ECS may be supplied to the emission driver EDC, the third control signal DCS may be supplied to the data driver DDC, and the fourth control signal PCS may be supplied to the power supply part PWS. The timing controller TC may rearrange the input image data IRGB in response to the pixels PXij (e.g., an arrangement thereof) in the display panel DP to generate the image data RGB (e.g., frame data).

The scan driver SDC, the emission driver EDC, the data driver DDC, the power supply part PWS, and/or the timing controller TC may be directly provided in the display panel DP, or may be provided in a separate driving chip to be connected to the display panel DP. In addition, at least two of the scan driver SDC, the emission driver EDC, the data driver DDC, the power supply part PWS, or the timing controller TC may be provided together in one driving chip. For example, the data driver DDC and the timing controller TC may be provided together as one driving chip.

While the display device DD according to an embodiment has been described with reference to FIG. 1, the present disclosure is not limited thereto. For example, signal lines may be further added or omitted according to the constitution of the pixel PXij. In addition, the connection relationship between one pixel and the signal lines may also be variously modified as needed or desired. When any one of the signal lines is omitted, another signal line may replace the omitted signal line.

FIGS. 2A through 2C are equivalent circuit diagrams of a pixel according to one or more embodiments of the present disclosure. FIGS. 2A to 2C show some example equivalent circuit diagrams of pixels PXij, PXij-1, and PXij-2 connected to an i-th first scan line GWLi (hereinafter, a write scan line) and a j-th data line DLj (hereinafter, a data line).

As shown in FIG. 2A, the pixel PXij includes a light emitting element LD and a pixel driver PDC. The light emitting element LD is connected to the first power line VDL and the pixel driver PDC.

The pixel driver PDC may be connected to the plurality of the scan lines GWLi, GCLi, GBLi, GILi, GRLi, the data line DLj, an emission line ESLi, and the plurality of the power lines VDL, VSL, VIL1, VIL2, VRL, and VCL. The pixel driver PDC may include first to eighth transistors T1, T2, T3, T4, T5, T6, T7, and T8, a first capacitor C1, and a second capacitor C2. Each of the first to eighth transistors T1, T2, T3, T4, T5, T6, T7, and T8 may be, for example, an N-type transistor. However, the present disclosure is not limited thereto, and some of the first to eighth transistors T1 to T8 may be N-type transistors, while the remainder thereof may be P-type transistors. As another example, each of the first to eighth transistors T1 to T8 may be a P-type transistor, but the present disclosure is not limited to any particular embodiment.

A gate of the first transistor T1 may be connected to a first node N1. A first electrode of the first transistor T1 may be connected to a second node N2, and a second electrode of the first transistor T1 may be connected to a third node N3. The first transistor T1 may be a driving transistor. The first transistor T1 may control a driving current ILD flowing to the second power line VSL from the first power line VDL via the light emitting element LD in response to the voltage of the first node N1. For example, the first power supply voltage VDD may have a higher potential than that of the second power supply voltage VSS.

As used herein, the expression "electrically connected between a transistor and a signal line, or between transistors" may mean that "a source, a drain, and a gate of the transistor have the shape integrated to the signal line, or are connected through connection electrodes".

The second transistor T2 may include a gate connected to the write scan line GWLi, a first electrode connected to the data line DLj, and a second electrode connected to the first node N1. The second transistor T2 may supply the data signal DATA to the first node N1 in response to the write scan signal GW transferred through the write scan line GWLi. When the write scan signal GW is supplied to the write scan line GWLi, the second transistor T2 may be turned on to connect the data line DLj and the first node N1 to each other.

The third transistor T3 may be connected between the first node N1 and the reference voltage line VRL. A first electrode of the third transistor T3 may receive the reference voltage VREF through the reference voltage line VRL, and a second electrode of the third transistor T3 may be connected to the first node N1. In an embodiment, a gate of the third transistor T3 may receive a reset scan signal GR through an i-th fifth scan line GRLi (hereafter, a reset scan line). When the reset scan signal GR is supplied to the reset scan line GRLi, the third transistor T3 may be turned on to supply the reference voltage VREF to the first node N1.

The fourth transistor T4 may be connected between the third node N3 and the first initialization voltage line VIL1. A first electrode of the fourth transistor T4 may be connected to the third node N3, and a second electrode of the fourth transistor T4 may be connected to the first initialization voltage line VIL1 through which the first initialization voltage VINT1 is supplied. The fourth transistor T4 may be referred to as a first initialization transistor. A gate of the fourth transistor T4 may receive a first initialization scan signal GI through an i-th third scan line GILi (hereinafter, a first initialization scan line). When the first initialization scan signal GI is supplied to the first initialization scan line GILi, the fourth transistor T4 may be turned on to supply the first initialization voltage VINT1 to the third node N3.

The fifth transistor T5 may be connected between the voltage compensation line VCL and the second node N2. A first electrode of the fifth transistor T5 may receive the compensation voltage VCOMP through the voltage compensation line VCL, and a second electrode of the fifth transistor T5 may be connected to the second node N2 to be electrically connected to the first electrode of the first transistor T1. A gate of the fifth transistor T5 may receive a compensation scan signal GC through the i-th second scan line GCLi (hereinafter, a compensation scan line). When the compensation scan signal GC is supplied to the compensation scan line GCLi, the fifth transistor T5 may be turned on to provide the compensation voltage VCOMP to the second node N2, and the threshold voltage of the first transistor T1 may be compensated for during a compensation period.

The sixth transistor T6 may be connected between the first electrode of the first transistor T1 and the light emitting element LD. In more detail, a gate of the sixth transistor T6 may receive an emission signal EM through the i-th emission line ESLi (hereinafter, an emission line). A first electrode of the sixth transistor T6 may be connected to the cathode of the light emitting element LD through a fourth node N4, and a second electrode of the sixth transistor T6 may be connected to the first electrode of the first transistor T1 through the second node N2. The sixth transistor T6 may be referred to as a first emission control transistor. When the emission signal EM is supplied to the emission line ESLi, the sixth transistor T6 may be turned on to electrically connect the light emitting element LD and the first transistor T1 to each other.

The seventh transistor T7 may be connected between the second power line VSL and the third node N3. A first electrode of the seventh transistor T7 may be connected to the second electrode of the first transistor T1 through the third node N3, and a second electrode of the seventh transistor T7 may receive the second power supply voltage VSS through the second power line VSL. A gate of the seventh transistor T7 may be electrically connected to the emission line ESLi. The seventh transistor T7 may be referred to as a second emission control transistor. When the emission signal EM is supplied to the emission line ESLi, the seventh transistor T7 may be turned on to electrically connect the second electrode of the first transistor T1 and the second power line VSL to each other.

In the embodiment, the sixth transistor T6 and the seventh transistor T7 are shown as being connected to the same emission line ESLi to be turned on by the same emission signal EM, but the present disclosure is not limited thereto. The sixth transistor T6 and the seventh transistor T7 may be individually turned on by different signals. In addition, in the pixel driver PDC according to an embodiment of the present disclosure, any one of the sixth transistor T6 or the seventh transistor T7 may be omitted as needed or desired.

The eighth transistor T8 may be connected between the second initialization voltage line VIL2 and the fourth node N4. In other words, the eighth transistor T8 may include a gate connected to the i-th fourth scan line GBLi (hereinafter, a second initialization scan line), a first electrode connected to the second initialization voltage line VIL2, and a second electrode connected to the fourth node N4. The eighth transistor T8 may be referred to as a second initialization transistor. The eighth transistor T8 may supply the second initialization voltage VINT2 to the fourth node N4 corresponding to the cathode of the light emitting element LD in response to the second initialization scan signal GB transferred through the second initialization scan line GBLi. The cathode of the light emitting element LD may be initialized by the second initialization voltage VINT2.

In an embodiment, some of the second to eight transistors T2, T3, T4, T5, T6, T7, and T8 may be concurrently or substantially simultaneously turned on with each other by the same scan signal. For example, the eighth transistor T8 and the fifth transistor T5 may be concurrently or substantially simultaneously turned on with each other by the same scan signal. For example, the eighth transistor T8 and the fifth transistor T5 may be operated by the same compensation scan signal GC. The eighth transistor T8 and the fifth transistor T5 may be concurrently or substantially simultaneously turned on/off with each other by the same compensation scan signal GC. In this case, the compensation scan line GCLi and the second initialization scan line GBLi may be provided as the same signal line (e.g., as a substantially single scan line). Accordingly, initialization of the cathode of the light emitting element LD may be achieved together with the threshold voltage compensation of the first transistor T1 at the same or substantially the same time. However, the present disclosure is not limited thereto.

In addition, according to an embodiment of the present disclosure, applying the same power supply voltage may lead to the initialization of the cathode of the light emitting element LD and the compensation for the threshold voltage of the first transistor T1. For example, the voltage compensation line VCL and the second initialization voltage line VIL2 may be provided as the same power supply line (e.g., as a substantially single power supply voltage line). In this case, the cathode initialization and the compensation of the driving transistor may be achieved with one power supply voltage, and thus, designing of the pixel driver PDC may be simplified. However, the present disclosure is not limited thereto.

The first capacitor C1 may be disposed between the first node N1 and the third node N3. The first capacitor C1 may store charges corresponding to a voltage difference between the first node N1 and the third node N3. The first capacitor C1 may be referred to as a storage capacitor.

The second capacitor C2 may be disposed between the third node N3 and the second power line VSL. In other words, one electrode of the second capacitor C2 may be connected to the second power line VSL to which the second power supply voltage VSS is supplied, and the other electrode of the second capacitor C2 may be connected to the third node N3. The second capacitor C2 may store charges corresponding to a voltage difference between the second power supply voltage VSS and the third node N3. The second capacitor C2 may be referred to as a hold capacitor. The second capacitor C2 may have a higher storage capacitance in comparison to that of the first capacitor C1. Accordingly, the second capacitor C2 may minimize or reduce the voltage change in the third node N3 in response to the voltage change in the first node N1.

In an embodiment, the light emitting element LD may be connected to the pixel driver PDC through the fourth node N4. The light emitting element LD may include an anode connected to the first power line VDL, and the cathode opposite thereto. In an embodiment, the light emitting element LD may be connected to the pixel driver PDC through the cathode. In other words, in the pixel PXij according to an embodiment of the present disclosure, a connection node at which the light emitting element LD is connected to the pixel driver PDC may be the fourth node N4, and the fourth node N4 may correspond to a connection node between the first electrode of the sixth transistor T6 and the cathode of the light emitting element LD. Accordingly, the potential of the fourth node N4 may correspond to or substantially correspond to a cathode potential of the light emitting element LD.

In more detail, the anode of the light emitting element LD may be connected to the first power line VDL to receive the first power supply voltage VDD that is a constant or substantially constant voltage, and the cathode may be connected to the first transistor T1 through the sixth transistor T6. In other words, in an embodiment in which the first to eighth transistors T1 to T8 are N-type transistors, the potential of the third node N3, which corresponds to the source of the first transistor T1 being a driving transistor, may not be affected directly by the characteristics of the light emitting element LD. Accordingly, even when the light emitting element LD is degraded, a gate-source voltage (Vgs) of the driving transistor from among the transistors constituting the pixel driver PDC may be less affected. In other words, the amount of change in a driving current ILD due to the degradation of the light emitting element LD may be reduced, and thus, afterimage defects of the display panel due to an increase in utilization time may be reduced and the lifetime may be enhanced.

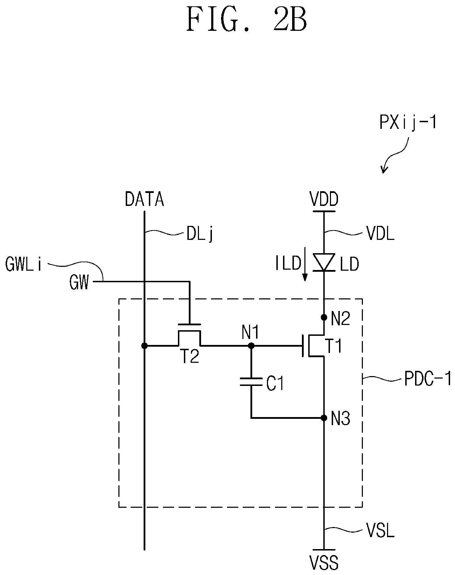

In another embodiment, as shown in FIG. 2B, the pixel PXij-1 may include a pixel driver PDC-1 including two transistors T1 and T2 and one first capacitor C1. The pixel driver PDC-1 may be connected to the light emitting element LD, the write scan line GWLi, the data line DLj, and the second power line VSL. The pixel driver PDC-1 shown in FIG. 2B may correspond to the pixel driver PDC described above with reference to FIG. 2A from which the third to eighth transistors T3 to T8 and the second capacitor C2 are omitted.

Each of the first and second transistors T1 and T2 may be an N-type transistor or a P-type transistor. For convenience, an example case in which each of the first and second transistors T1 and T2 is an N-type transistor is illustrated in FIG. 2B.

The first transistor T1 includes a gate connected to a first node N1, a first electrode connected to a second node N2, and a second electrode connected to a third node N3. The second node N2 may be connected to a first power line VDL side, and the third node N3 may be connected to a second power line VSL side. The first transistor T1 is connected to the light emitting element LD through the second node N2, and connected to the second power line VSL through the third node N3. The first transistor T1 may be the driving transistor.

The second transistor T2 may include a gate configured to receive the write scan signal GW through the write scan line GWLi, a first electrode connected to the data line DLj, and a second electrode connected to the first node N1. The second transistor T2 may supply the data signal DATA to the first node N1 in response to the write scan signal GW transferred through the write scan line GWLi.

The first capacitor C1 may include an electrode connected to the first node N1 and an electrode connected to the third node N3. The first capacitor C1 may store the data signal DATA transferred to the first node N1.

The light emitting element LD may include an anode and a cathode. In an embodiment, the anode of the light emitting element LD is connected to the first power line VDL, and the cathode is connected to the pixel driver PDC-1 through the second node N2. In an embodiment, the cathode of the light emitting element LD may be connected to the first transistor T1. The light emitting element LD may emit light in response to the amount of current ILD flowing through the first transistor T1 of the pixel driver PDC-1.

In an embodiment where the first and second transistors T1 and T2 are N-type transistors, the second node N2 at which the light emitting element LD is connected to the pixel driver PDC-1 may correspond to the drain of the first transistor T1. In other words, a change in the gate-source voltage (Vgs) of the first transistor T1 due to the light emitting element LD may be prevented or substantially prevented. In other words, the amount of change in the driving current ILD due to a degradation of the light emitting element LD may be reduced, and thus, afterimage defects of the display panel due to an increase in a utilization time may be reduced and the lifetime may be enhanced.

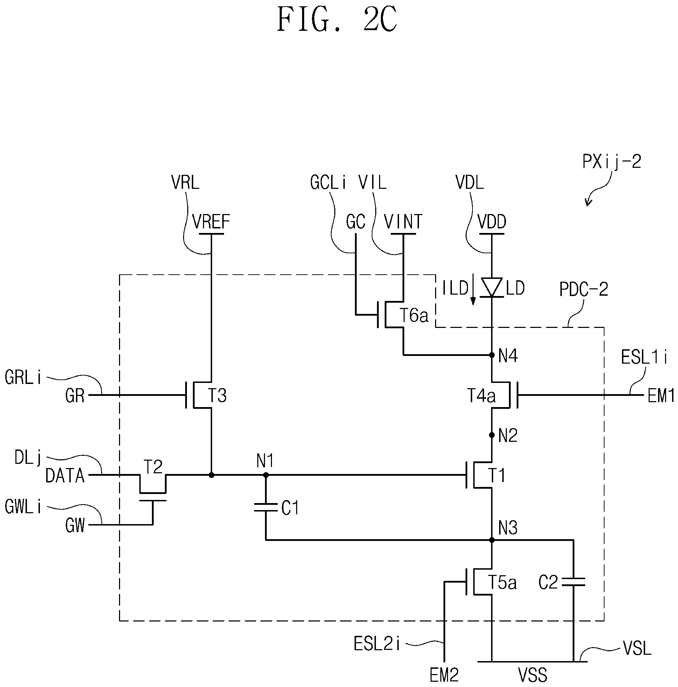

In another embodiment, as shown in FIG. 2C, the pixel PXij-2 may include a pixel driver PDC-2 including six transistors T1, T2, T3, T4a, T5a, and T6a and two capacitors C1 and C2.

The pixel driver PDC-2 may be connected to the light emitting element LD, the write scan line GWLi, the reset scan line GRLi, the compensation scan line GCLi, an i-th first emission line ESL1i (hereinafter, a first emission line), an i-th second emission line ESL2i (hereinafter, a second emission line), the data line DLj, the first power line VDL, the second power line VSL, the third power line VRL, and the initialization voltage line VIL.

The pixel driver PDC-2 in FIG. 2C may be similar to a structure in which the fourth transistor T4 and the fifth transistor T5 are omitted from the pixel driver PDC described above with reference to FIG. 2A. As the area of the pixel driver PDC-2 in FIG. 2C is smaller than that of the pixel driver PDC in FIG. 2A, a high resolution may be implemented (e.g., may be easily implemented).

Each of the first to sixth transistors T1, T2, T3, T4a, T5a, and T6a may be an N-type transistor or a P-type transistor. In an embodiment, an example case in which the first to sixth transistors T1, T2, T3, T4a, T5a, and T6a are N-type transistors may be described in more detail hereinafter for convenience.

The first transistor T1 includes a gate connected to a first node N1, a first electrode connected to a second node N2, and a second electrode connected to a third node N3. The second node N2 may be connected to a first power line VDL side, and the third node N3 may be connected to a second power line VSL side. The first transistor T1 is connected to the light emitting element LD through the second node N2, and to the second power line VSL through the third node N3. The first transistor T1 may be the driving transistor.

The second transistor T2 may include a gate configured to receive the write scan signal GW through the write scan line GWLi, a first electrode connected to the data line DLj, and a second electrode connected to the first node N1. The second transistor T2 may supply the data signal DATA to the first node N1 in response to the write scan signal GW transferred through the write scan line GWLi.

The third transistor T3 may be connected between the first node N1 and the reference voltage line VRL. A first electrode of the third transistor T3 may receive the reference voltage VREF through the reference voltage line VRL, and a second electrode of the third transistor T3 may be connected to the first node N1. In an embodiment, a gate of the third transistor T3 may receive the reset scan signal GR through the reset scan line GRLi. When the reset scan signal GR is supplied to the reset scan line GRLi, the third transistor T3 may be supply the reference voltage VREF to the first node N1.

The fourth transistor T4a may be connected between the first electrode of the first transistor T1 and the light emitting element LD. In more detail, a gate of the fourth transistor T4a may receive the first emission signal EM1 through the first emission line ESL1i. A first electrode of the fourth transistor T4a may be connected to the cathode of the light emitting element LD through the fourth node N4, and a second electrode of the fourth transistor T4a may be connected to the first electrode of the first transistor T1 through the second node N2. The fourth transistor T4a may be referred to as the first emission control transistor. When the first emission signal EM1 is supplied to the first emission line ESL1i, the fourth transistor T4a may be turned on to electrically connect the light emitting element LD and the first transistor T1 to each other.

The fifth transistor T5a may be connected between the second power line VSL and the third node N3. A first electrode of the fifth transistor T5a may be connected to the second electrode of the first transistor T1 through the third node N3, and a second electrode of the fifth transistor T5a may receive the second power supply voltage VSS through the second power line VSL. A gate of the fifth transistor T5a may be electrically connected to the second emission line ESL2i. The fifth transistor T5a may be referred to as a second emission control transistor. When the second emission signal EM2 is supplied to the second emission line ESL2i, the fifth transistor T5a may be turned on to electrically connect the second electrode of the first transistor T1 and the second power line VSL to each other.

In an embodiment, the fourth transistor T4a and the fifth transistor T5a may be respectively connected to the first and second emission lines ESL1i and ESL2i to be turned on by the first and second emission signals EM1 and EM2. In other words, the fourth transistor T4a and the fifth transistor T5a may be individually turned on. However, the present disclosure is not limited thereto. For example, in an embodiment of the present disclosure, the fourth transistor T4a and the fifth transistor T5a may be connected to the same emission line, and may be controlled by the same emission signal. In addition, in the pixel driver PDC-2 according to an embodiment of the present disclosure, any one of the fourth transistor T4a or the fifth transistor T5a may be omitted as needed or desired.

The sixth transistor T6a may be connected between the initialization voltage line VIL and the fourth node N4. The sixth transistor T6a may include a gate connected to the compensation scan line GCLi, a first electrode connected to the initialization voltage line VIL, and a second electrode connected to the fourth node N4. The sixth transistor T6a may be referred to as the initialization transistor. The sixth transistor T6a may supply the initialization voltage VINT to the fourth node N4 corresponding to the cathode of the light emitting element LD in response to the compensation scan signal GC transferred through the compensation scan line GCLi. The cathode of the light emitting element LD may be initialized by the initialization voltage VINT.

The first capacitor C1 may be disposed between the first node N1 and the third node N3. The first capacitor C1 may store charges corresponding to the voltage difference between the first node N1 and the third node N3. The first capacitor C1 may be referred to as the storage capacitor.

The second capacitor C2 may be disposed between the third node N3 and the second power line VSL. In other words, one electrode of the second capacitor C2 may be connected to the second power line VSL to receive the second power supply voltage VSS supplied thereto, and the other electrode of the second capacitor C2 may be connected to the third node N3. The second capacitor C2 may store charges corresponding to the voltage difference between the second power supply voltage VSS and the third node N3. The second capacitor C2 may be referred to as the hold capacitor.

The light emitting element LD may include an anode and the cathode. In an embodiment, the anode of the light emitting element LD is connected to the first power line VDL, and the cathode is connected to the pixel driver PDC-2 through the fourth node N4. In an embodiment, the cathode of the light emitting element LD may be connected to the first transistor T1 through the fourth transistor T4a. The light emitting element LD may emit light corresponding to the amount of current ILD flowing through the first transistor T1 of the pixel driver PDC-2.

In an embodiment in which the first to sixth transistors T1, T2, T3, T4a, T5a, and T6a are N-type transistors, the potential of the third node N3 corresponding to the source of the first transistor T1 as the driving transistor may not be directly affected by the characteristics of the light emitting element LD. Accordingly, even when the light emitting element LD is degraded, the degradation may affect less the gate-source voltage (Vgs) of the driving transistor from among the transistors constituting the pixel driver PDC-2. In other words, the amount of change in a driving current due to the degradation of the light emitting element LD may be reduced, and thus, afterimage defects of the display panel due to an increase in a utilization time may be reduced and the lifetime may be enhanced.

FIGS. 2A, 2B, and 2C show the pixel drivers PDC, PDC-1, and PDC-2 according to some embodiments of the present disclosure, and the display panel according to an embodiment of the present disclosure may be designed in various suitable ways in terms of the number or the arrangement relationship of the transistors or the capacitors, and thus, is not limited to any particular embodiment, so long as the pixel driver is connected to the cathode of the light emitting element LD.

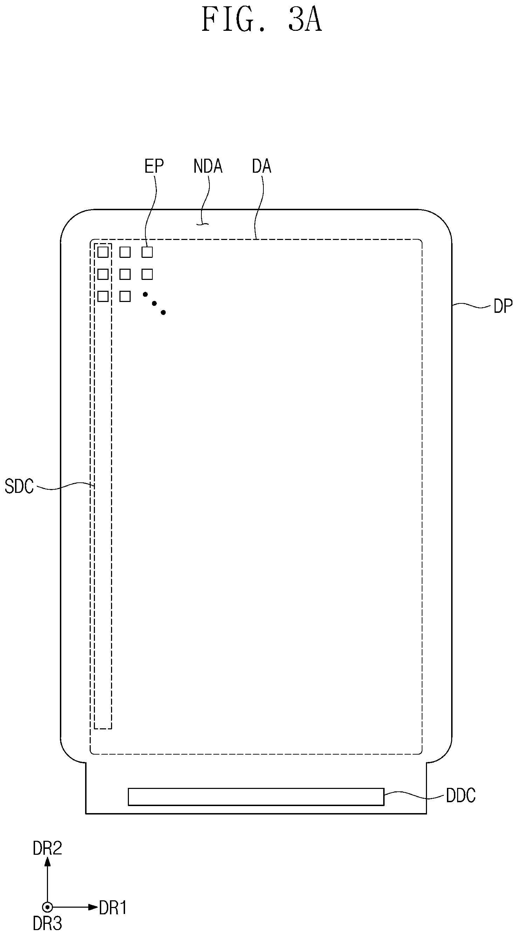

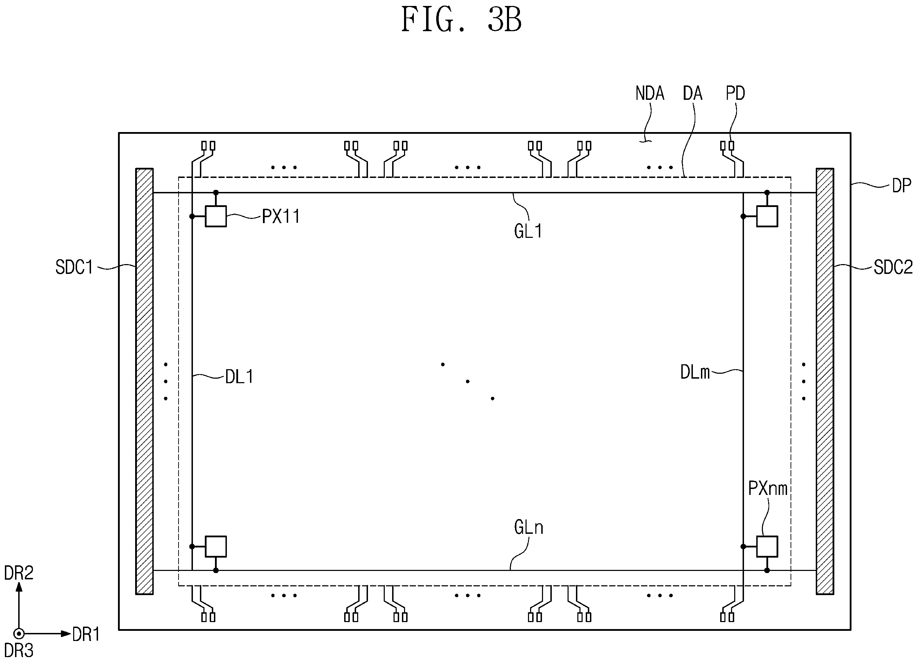

FIGS. 3A and 3B are plan views of a display panel according to one or more embodiments of the present disclosure. In each of FIGS. 3A and 3B, some components are not shown for convenience of illustration. Hereinafter, some embodiments of the present disclosure will be described in more detail with reference to FIGS. 3A and 3B.

Referring to FIG. 3A, the display panel DP in accordance with an embodiment may be divided into a display area DA and a peripheral area (e.g., a non-display area) NDA. The display area DA includes a plurality of light emitting parts EP.

The light emitting parts EP may be an area in which a corresponding pixel PXij (e.g., see FIG. 1) emits light. In more detail, each of the light emitting parts EP may correspond to a corresponding emission opening OP-PDL to be described in more detail below.

The peripheral area NDA may be disposed adjacent to the display area DA. In an embodiment, the peripheral area NDA may surround (e.g., around a periphery of) an edge of the display area DA. However, the present disclosure is not limited thereto, and the peripheral area NDA may be disposed in one side (e.g., only in one side) of the display area DA, or be omitted as needed or desired.

In an embodiment, the scan driver SDC and the data driver DDC may be mounted in the display panel DP. In an embodiment, the scan driver SDC may be disposed in the display area DA, and the data driver DDC may be disposed in the peripheral area NDA. The scan driver SDC may overlap with at least some of the plurality of light emitting parts EP disposed in the display area DA in a plan view. Because the scan driver SDC is disposed in the display area DA, the area of the peripheral area NDA may be reduced in comparison to that of a comparative display panel in which a scan driver is disposed in the peripheral area, and thus, a display device with a thinner bezel may be implemented (e.g., may be easily implemented).

However, the present disclosure is not limited thereto, and unlike that shown in FIG. 3A, the scan driver SDC may include two separate parts. The two scan drivers SDC may be spaced apart from each other in a horizontal direction with the center of the display area DA interposed therebetween. As another example, the scan driver SDC may have two or more portions that are distinguished from each other, and the present disclosure is not limited to any particular embodiment.

While FIG. 3A shows an example of the display panel DP in which the data driver DDC is disposed in the peripheral area NDA, the present disclosure is not limited thereto, and the data driver DDC may be disposed in the display area DA. In this case, some of the light emitting parts EP disposed in the display area DA may overlap with the data driver DDC in a plan view.

In an embodiment, the data driver DDC may be provided in a driving chip separately from the display panel DP to be connected to the display panel DP. However, the present disclosure is not limited thereto, and the data driver DDC may be provided in the same process as that of the scan driver SDC in order to constitute the display panel DP, and the present disclosure is not limited to any particular embodiment.

Referring to FIG. 3B, the display panel DP may have a shape in which the length thereof in a first direction DR1 is longer than that in a second direction DR2. As an example, a plurality of pixels PX11 to PXnm may be arranged in n rows and m columns in the display area DA, where n and m are integers greater than 1. In an embodiment, the display panel DP may include a plurality of scan drivers SDC1 and SDC2. The scan drivers SDC1 and SDC2 may include a first scan driver SDC1 and a second scan driver SDC2 that are spaced apart from each other in the first direction DR1.

The first scan driver SDC1 may be connected to some of the scan lines GL1 to GLn, and the second scan driver SDC2 may be connected to the others of the scan lines GL1 to GLn. For example, the first scan driver SDC1 may be connected to the odd scan lines from among the scan lines GL1 to GLn, and the second scan driver SDC2 may be connected to the even scan lines from among the scan lines GL1 to GLn.

FIG. 3B shows pads PD of the data lines DL1 to DLm for convenience of illustration. The pads PD may be defined at an end of the data lines DL1 to DLm. The data lines DL1 to DLm may be connected to the data driver DDC (e.g., see FIG. 3A) through the pads PD.

According to an embodiment of the present disclosure, some of the pads PD may be disposed in the peripheral area NDA at positions at which the pads PD are spaced apart from each other with the display area DA interposed therebetween. For example, some of the pads PD may be disposed in an upper side, such as the side adjacent to the first scan line GL1 from among the scan lines GL1 to GLn, and the others of the pads PD may be disposed in a lower side, such as the side adjacent to the last scan line GLn from among the scan lines GL1 to GLn. In an embodiment, the pads PD connected to odd data lines from among the data lines DL1 to DLm may be disposed in the upper side, and the pads PD connected to even data lines from among the data lines DL1 to DLm may be disposed in the lower side.

The display panel DP may include a plurality of upper data drivers connected to the pads PD disposed in the upper side and/or a plurality of lower data drivers connected to the pads PD disposed in the lower side. However, the present disclosure is not limited thereto, and the display panel DP may include one upper data driver connected to the pads PD disposed in the upper side and/or one lower data driver connected to the pads PD disposed in the lower side. The pads PD according to an embodiment of the present disclosure may also be disposed at one side (e.g., only at one side) of the display panel DP to be connected to a single data driver, and the present disclosure is not limited to any particular embodiment.

In addition, as described above with reference to FIG. 3A, the display panel DP in FIG. 3B may also include the scan driver and/or the data driver disposed in the display area DA, and accordingly, some of the light emitting parts disposed in the display area DA may overlap with the scan driver and/or the data driver in a plan view.

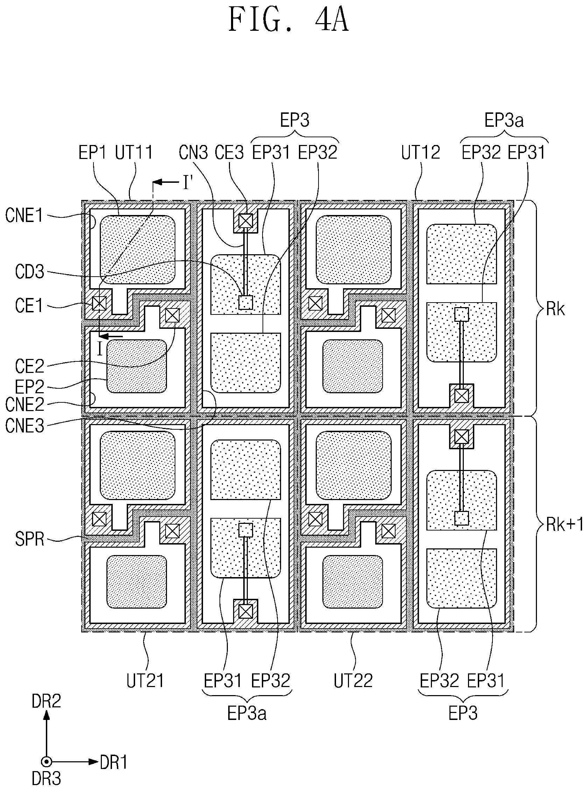

FIGS. 4A through 4D are enlarged plan views of partial areas of a display panel according to one or more embodiments of the present disclosure.

FIG. 4A illustrates an example of light emitting units (e.g., light emitting unit areas) UT11, UT12, UT21, and UT22 arranged in two rows and two columns. Each light emitting unit UT11, UT12, UT21, and UT22 may be an area where a plurality of light emitting parts EP1, EP2, and EP3 are disposed. Referring to FIG. 4A, the light emitting parts EP1, EP2, and EP3 in a first row Rk constitute the light emitting unit UT11 in the first row Rk and first column, and the light emitting unit UT12 in the first row Rk and second column. The light emitting parts EP1, EP2, and EP3 in a second row Rk+1 constitute the light emitting unit UT21 in the second row Rk+1 and the first column, and the light emitting unit UT22 in the second row Rk+1 and the second column.

The light emitting parts EP1, EP2, and EP3 may correspond to the emission openings OP-PDL, respectively, to be described in more detail below. In more detail, each of the light emitting parts EP1, EP2, and EP3 may be an area in which light is emitted by a corresponding light emitting element. The light emitting parts EP1, EP2, and EP3 may correspond to units (e.g., minimum units) used to compose an image displayed on the display panel DP (e.g., see FIG. 1). In more detail, the light emitting parts EP1, EP2, and EP3 may correspond to an area defined by the emission openings OP-PDL, and may correspond to an area defined by the bottom surface of the emission openings OP-PDL.

The light emitting parts EP1, EP2, and EP3 may include the first light emitting part EP1, the second light emitting part EP2, and the third light emitting part EP3. The first light emitting part EP1, the second light emitting part EP2, and the third light emitting part EP3 may emit different colored light from each other. For example, the first light emitting part EP1 may emit red light, the second light emitting part EP2 may emit green light, and the third light emitting part EP3 may emit blue light, but the present disclosure is not limited thereto, and the color combination of light emitted from the light emitting parts EP1, EP2, and EP3 may be variously modified as needed or desired. In some embodiments, at least two of the light emitting parts EP1, EP2, and EP3 may emit the same colored light as each other. For example, all of the first to third light emitting parts EP1, EP2, EP3 may emit blue light or white light.

The third light emitting part EP3 may emit light emitted by the third light emitting element from among the light emitting parts EP1, EP2, and EP3, and may include two sub-light emitting parts EP31 and EP32 that are spaced apart from each other in the second direction DR2. However, the present disclosure is not limited thereto, and the third light emitting part EP3 may be provided with one integral-shaped pattern, similarly to those of the first and second light emitting parts EP1 and EP2. As another example, at least one of the first or second light emitting parts EP1 or EP2 may also include sub-light emitting parts that are spaced apart from each other, and the present disclosure is not limited to any particular embodiment.

The light emitting parts in the first row Rk may include the first to third light emitting parts EP1, EP2, and EP3 constituting the light emitting unit UT11 in the first row Rk and the first column, and the first to third light emitting parts EP1, EP2, and EP3 (e.g., EP3a) constituting the light emitting unit UT12 in the first row Rk and the second column. The light emitting parts in the second row Rk+1 may include the first to third light emitting parts EP1, EP2, and EP3 (e.g., EP3a) constituting the light emitting unit UT21 in the second row Rk+1 and the first column, and the first to third light emitting parts EP1, EP2, and EP3 constituting the light emitting unit UT22 in the second row Rk+1 and the second column.

In an embodiment of the present disclosure, the light emitting parts constituting the light emitting unit UT11 in the first row Rk and the first column may have the same or substantially the same shape as those constituting the light emitting unit UT22 in the second row Rk+1 and the second column. In addition, the light emitting parts constituting the light emitting unit UT12 in the first row Rk and the second column may have the same or substantially the same shapes as those constituting the light emitting unit UT21 in the second row Rk+1 and the first column. The light emitting parts constituting the light emitting unit UT11 in the first row Rk and the first column may have different shapes from those constituting the light emitting unit UT12 in the first row Rk and the second column. For example, a portion of the light emitting parts in the first row Rk may have a symmetrical shape with respect to the light emitting parts in the second row Rk+1.

In an embodiment of the present disclosure, the third light emitting part EP3a of the light emitting unit UT21 in the second row Rk+1 and the first column and the third light emitting part EP3 of the light emitting unit UT11 in the first row Rk and the first column may have a linearly symmetrical shape and arrangement form with respect to an axis that is parallel to the first direction DR1. The third light emitting part EP3a of the light emitting unit UT12 in the first row Rk and the second column and the third light emitting part EP3 of the light emitting unit UT22 in the second row Rk+1 and the second column may have a linearly symmetrical shape and arrangement form with respect to an axis that is parallel to the first direction DR1. However, the present disclosure is not limited thereto.

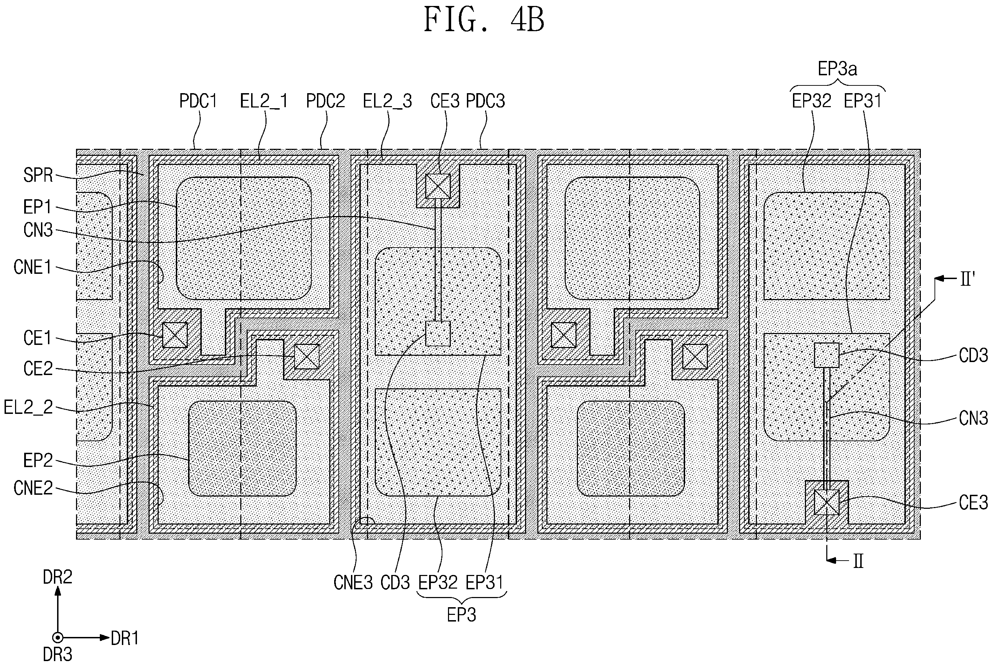

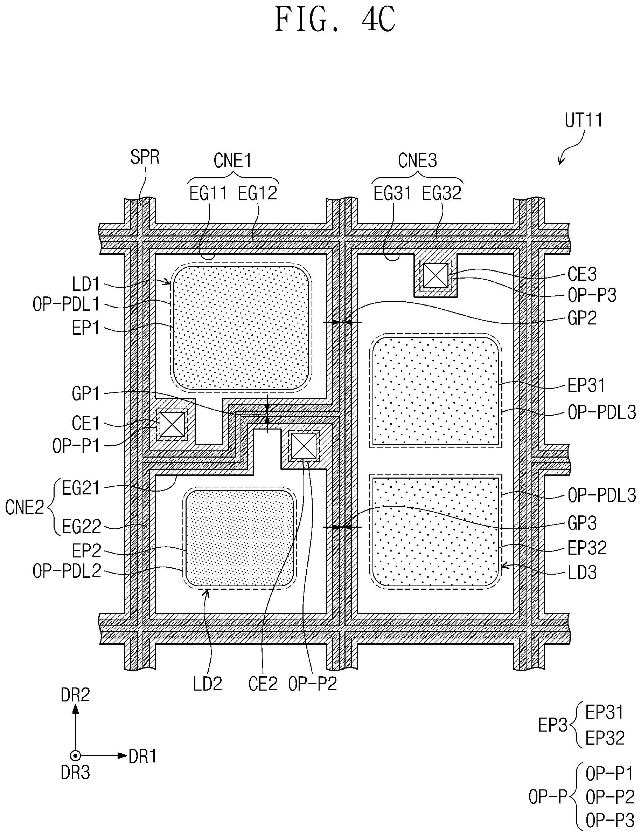

FIG. 4B illustrates the light emitting parts arranged in one row. For convenience of illustration, FIG. 4B illustrates a plurality of second electrodes EL2_1, EL2_2, and EL2_3, a plurality of pixel drivers PDC1, PDC2, and PDC3, first to third connection electrodes CNE1, CNE2, and CNE3, and a separator SPR. FIG. 4C illustrates, from among the components of the display panel DP, the separator SPR, the plurality of light emitting parts EP1, EP2, and EP3 disposed in an area divided by the separator SPR, and the plurality of connection electrodes CNE1, CNE2, and CNE3.

Referring to FIGS. 4B and 4C, the second electrodes EL2_1, EL2_2, and EL2_3 may be separated from each other by the separator SPR, and may be electrically disconnected from each other. In an embodiment, one light emitting unit UT11 may include three light emitting parts EP1, EP2, and EP3. Accordingly, the light emitting unit UT11 may include the three second electrodes EL2_1, EL2_2, and EL2_3 (hereinafter, referred to as first to third cathodes), the three pixel drivers PDC1, PDC2, and PDC3, and the three connection electrodes CNE1, CNE2, and CNE3. However, the present disclosure is not limited thereto, and the number and the arrangement of the light emitting parts included in the light emitting unit UT11 may be variously modified as needed or desired.

The first to third pixel drivers PDC1, PDC2, and PDC3 may be electrically connected to the light emitting elements LD1, LD2, and LD3 including the first to third light emitting parts EP1, EP2, and EP3, respectively. As used herein, the term "connected" may include a case of being physically directly connected to each other by a contact, as well as a case of being electrically connected to each other.

In addition, as shown in FIG. 4B, areas in which the first to third pixel drivers PDC1, PDC2, and PDC3 are respectively defined in a plan view may correspond to a unit in which the transistors and capacitors constituting the pixel driver (pixel circuit) PDC (e.g., see FIG. 2A) for driving the light emitting element of a pixel are repetitively arranged.

The first to third pixel drivers PDC1, PDC2, and PDC3 may be sequentially arranged along the first direction DR1. However, the arrangement positions of the first to third pixel drivers PDC1, PDC2, and PDC3 may designed regardless of the positions and the shapes of the first to third light emitting parts EP1, EP2, and EP3.

For example, the first to third pixel drivers PDC1, PDC2, and PDC3 may be arranged in areas divided and defined by the separator SPR. The first to third pixel drivers PDC1, PDC2, and PDC3 may be arranged in positions different from the positions at which the first to third cathodes EL2_1, EL2_2, and EL2_3 are disposed, or may have the areas and the shapes different from the shapes of the first to third cathodes EL2_1, EL2_2, and EL2_3. As another example, the first to third pixel drivers PDC1, PDC2, and PDC3 may be arranged to overlap with the positions at which the first to third light emitting parts EP1, EP2, and EP3 are present, respectively, and may also have the areas similar to the areas divided and defined by the separator SPR, for example, such as the areas of the first to third cathodes EL2_1, EL2_2, and EL2_3.

In an embodiment, each of the first to third pixel drivers PDC1, PDC2, and PDC3 is shown as having a rectangular shape, and each of the first to third light emitting parts EP1, EP2, and EP3 is shown as being arranged to have a smaller area than and a different type from those of the first to third pixel drivers. The first to third cathodes EL2_1, EL2_2, and EL2_3 may be disposed to overlap with the first to third light emitting parts EP1, EP2, and EP3, respectively, and may have irregular shapes.

As such, as shown in FIG. 4B, the first pixel driver PDC1 may be disposed to partially overlap with the first light emitting part EP1, the second light emitting part EP2, and another adjacent light emitting part. The second pixel driver PDC2 may be disposed to overlap with the first light emitting part EP1, the second light emitting part EP2, and the third cathode EL2_3. The third pixel driver PDC3 may be disposed to overlap with the third light emitting part EP3. However, the present disclosure is not limited thereto, the first to third pixel drivers PDC1, PDC2, and PDC3 may have various suitable shapes and arrangements regardless of the first to third light emitting parts EP1, EP2, and EP3.

The light emitting unit UT11 may include first to third connection electrodes CNE1, CNE2, and CNE3. The first connection electrode CNE1 may electrically connect the first light emitting element LD1 and the first pixel driver PDC1 constituting (e.g., defining) the first light emitting part EP1 with each other. The second connection electrode CNE2 may connect the second light emitting element LD2 and the second pixel driver PDC2 constituting (e.g., defining) the second light emitting part EP2 with each other. The third connection electrode CNE3 may connect the third light emitting element LD3 and the third pixel driver PDC3 constituting (e.g., defining) the third light emitting part EP3 with each other. Each of the first to third light emitting elements LD1, LD2, and LD3 may include a first electrode EL1, an intermediate layer IML disposed on the first electrode EL1, and a second electrode EL2 disposed on the intermediate layer IML.

In more detail, the first to third connection electrodes CNE1, CNE2, and CNE3 may connect the first to third cathodes EL2_1, EL2_2, and EL2_3 in a one-to-one correspondence with the first to third pixel drivers PDC1, PDC2, and PDC3. For example, the first connection electrode CNE1 may be electrically connected to the first pixel driver PDC1 and the first cathode EL2_1, the second connection electrode CNE2 may be electrically connected to the second pixel driver PDC2 and the second cathode EL2_2, and the third connection electrode CNE3 may be electrically connected to the third pixel driver PDC3 and the third cathode EL2_3.

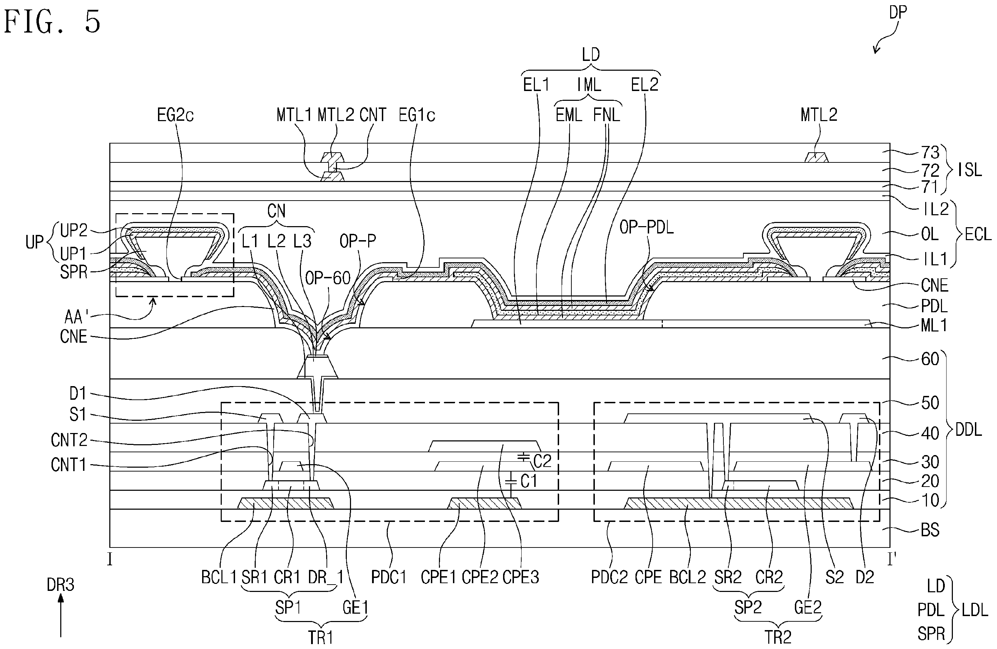

The first to third connection electrodes CNE1, CNE2, and CNE3 may be arranged on a pixel definition layer PDL (e.g., see FIG. 5) to be described in more detail below. The first to third connection electrodes CNE1, CNE2, CNE3 may have a ring shape surrounding (e.g., around peripheries of) the corresponding first to third light emitting parts EP1, EP2, and EP3. In an embodiment of the present disclosure, each of the first to third connection electrodes CNE1, CNE2, and CNE3 is shown as having a ring shape of a closed line, but the present disclosure is not limited thereto. For example, at least a portion of the first to third connection electrodes CNE1, CNE2, and CNE3 may have an open ring shape of which a portion thereof is disconnected.

As the first to third connection electrodes CNE1, CNE2, and CNE3 have the ring shape, the degrees of freedom in the positions at which the first to third connection electrodes CNE1, CNE2, and CNE3 are respectively connected to the first to third pixel drivers PDC1, PDC2, and PDC3 may be improved. For example, the first connection electrode CNE1 may be connected to the first pixel driver PDC1 through a first connection part CE1, the second connection electrode CNE2 may be connected to the second pixel driver PDC2 through a second connection part CE2, and the third connection electrode CNE3 may be connected to the third pixel driver PDC3 through a connection line CN3. However, there may be no connection lines additionally connected to the first and second connection electrodes CNE1 and CNE2.

One connection line CN3 may electrically connect the third pixel driver PDC3 and the third light emitting element LD3 constituting the third light emitting part EP3 with each other. In more detail, the connection line CN3 may correspond to a node (e.g., the fourth node N4 in FIG. 2A, the second node N2 in FIG. 2B, or the fourth node N4 in FIG. 2C) at which the light emitting element LD is connected to the pixel driver (e.g., PDC in FIG. 2A, PDC-1 in FIG. 2B, or PDC-2 in FIG. 2C).

The connection line CN3 may include the third connection part CE3 and a driving connection part CD3. The third connection part CE3 may be provided to one side of the connection line CN3, and the driving connection part CD3 may be provided to another side (e.g., an opposite side) of the connection line CN3.

The driving connection part CD3 may be a portion connected to the third pixel driver PDC3 in the connection line CN3. In an embodiment, the driving connection part CD3 may be connected to one electrode of a transistor constituting the third pixel driver PDC3. In more detail, the driving connection part CD3 may be connected to the drain of the sixth transistor T6 in FIG. 2A, or to the drain of the fourth transistor T4a in FIG. 2C. Accordingly, the position of the driving connection part CD3 may correspond to the position of the transistor that is physically connected to the connection line CN3 in the corresponding pixel driver PDC3. The third connection part CE3 may be a portion connected to the third light emitting element LD3 in the connection line CN3. In an embodiment, the third connection part CE3 may be connected to the third connection electrode CNE3.

The first connection electrode CNE1 may include a first edge EG11 surrounding (e.g., around a periphery of) at least a portion of the first light emitting part EP1, and a second edge EG12 surrounding (e.g., around a periphery of) the first edge EG11. The second connection electrode CNE2 may include a first edge EG21 surrounding (e.g., around a periphery of) at least a portion of the second light emitting part EP2, and a second edge EG22 surrounding (e.g., around a periphery of) the first edge EG21. The third connection electrode CNE3 may include a first edge EG31 surrounding (e.g., around a periphery of) at least a portion of the third light emitting part EP3, and a second edge EG32 surrounding (e.g., around a periphery of) the first edge EG31.

The first to third connection electrodes CNE1, CNE2, and CNE3 may be spaced apart from each other. For example, gaps GP1, GP2, and GP3 between a plurality of adjacent connection electrodes from among the first to third connection electrodes CNE1, CNE2, and CNE3 may overlap with the separator SPR. For example, the first edges EG11, EG21, and EG31 of the first to third connection electrodes CNE1, CNE2, and CNE3 may not be covered by the separator SPR, and the second edges EG12, EG22, and EG32 of the first to third connection electrodes CNE1, CNE2, and CNE3 may overlap with the separator SPR. As another example, the second edges EG12, EG22, and EG32 of the first to third connection electrodes CNE1, CNE2, and CNE3 may be covered by the separator SPR.

In an embodiment of the present disclosure, the first to third connection parts CE1, CE2, and CE3 may be disposed at non-overlapping positions with the light emitting parts EP1, EP2, and EP3 in a plan view. For example, the emission opening OP-PDL (e.g., see FIG. 5) and through-holes OP-P that are spaced apart from the emission opening OP-PDL may be defined in the pixel definition layer PDL.

The through-holes OP-P may include a first through-hole OP-P1, a second through-hole OP-P2, and a third through-hole OP-P3. The first to third connection parts CE1, CE2, and CE3 may be arranged corresponding to the first to third through-holes OP-P1, OP-P2, and OP-P3, respectively. The emission opening OP-PDL may include a first emission opening OP-PDL1, a second emission opening OP-PDL2, and a third emission opening OP-PDL3. The first to third light emitting parts EP1, EP2, and EP3 may be defined corresponding to the first to third emission openings OP-PDL1, OP-PDL2, OP-PDL3, respectively. Accordingly, the first to third connection parts CE1, CE2, and CE3 may be spaced apart from the first to third light emitting parts EP1, EP2, and EP3.

The first to third connection electrodes CNE1, CNE2, and CNE3 may be arranged on the pixel definition layer PDL (e.g., see FIG. 5). In a plan view, the first connection electrode CNE1 may surround (e.g., around a periphery of) the first emission opening OP-PDL1, the second connection electrode CNE2 may surround (e.g., around a periphery of) the second emission opening OP-PDL2, and the third connection electrode CNE3 may surround (e.g., around a periphery of) the third emission opening OP-PDL3.

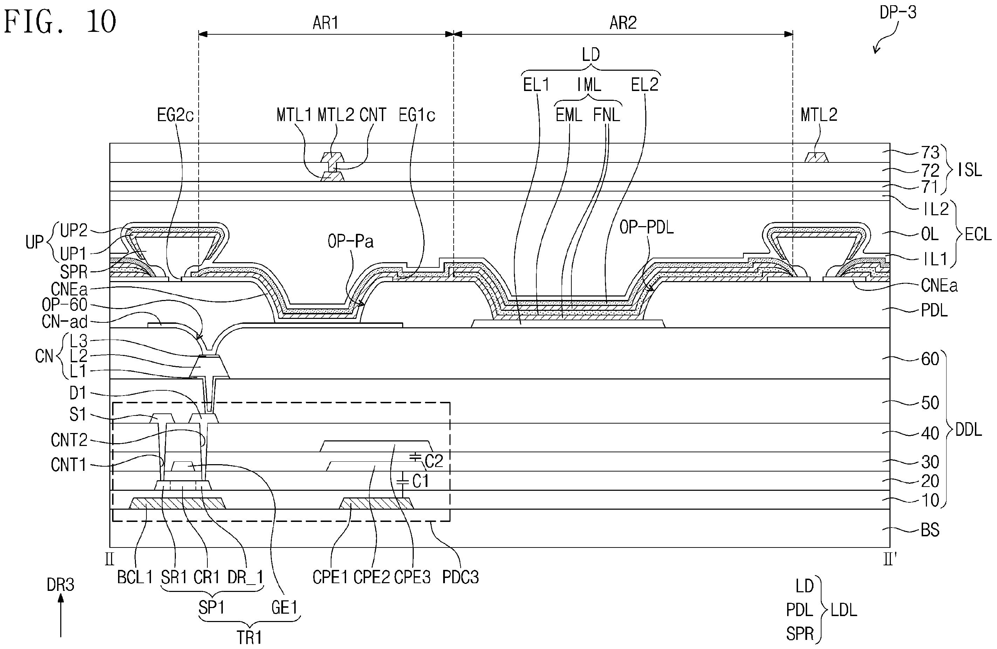

According to an embodiment of the present disclosure, the driving connection part CD3 at which the connection line CN3 is connected with the transistor TR (e.g., see FIG. 5) of the third pixel driver PDC3 may be defined at a non-overlapping position with the third connection part CE3 in a plan view, and may be disposed at an overlapping position with the third light emitting part EP3. For example, the connection line CN3 may correspond to a connection line CN-ad described in more detail below with reference to FIG. 10, the driving connection part CD3 may correspond to a portion in contact with an intermediate connection electrode CN in FIG. 10. The third connection part CE3 may correspond to a portion in contact with a connection electrode CNEa in FIG. 10. As the third cathode EL2_3 is connected to the pixel driver PDC3 through the connection line CN3, constraints according to the position or the shape of the third light emitting part EP3 may be reduced to increase the degrees of freedom in design thereof.

The first to third cathodes EL2_1, EL2_2, and EL2_3 may be connected with the first to third connection electrodes CNE1, CNE2, and CNE3. For example, the bottom surfaces of the first to third cathodes EL2_1, EL2_2, and EL2_3 may be connected with (e.g., may contact) the top surfaces of the first to third connection electrodes CNE1, CNE2, and CNE3. Accordingly, a contact reliability (e.g., a connection stability) may be further improved between the first to third cathodes EL2_1, EL2_2, and EL2_3 and the first to third connection electrodes CNE1, CNE2, and CNE3.

In addition, connection areas in which the first to third cathodes EL2_1, EL2_2, and EL2_3 are connected with the first to third connection electrodes CNE1, CNE2, and CNE3 may respectively surround (e.g., around peripheries of) at least portions of the first to third emission openings OP-PDL1, OP-PDL2, and OP-PDL3. The first to third cathodes EL2_1, EL2_2, and EL2_3 may be connected with the first to third connection electrodes CNE1, CNE2, and CNE3, respectively, in areas adjacent to the separator SPR, and each of the connection areas may be defined adjacent to the separator SPR. For example, the first to third cathodes EL2_1, EL2_2, and EL2_3 may be connected with the first to third connection electrodes CNE1, CNE2, and CNE3 not at specific points, but in relatively wider areas, for example, such as across areas having similar shapes as those of the first to third connection electrodes CNE1, CNE2, and CNE3. As such, the areas of the connection areas may be increased to enable more stable connections.

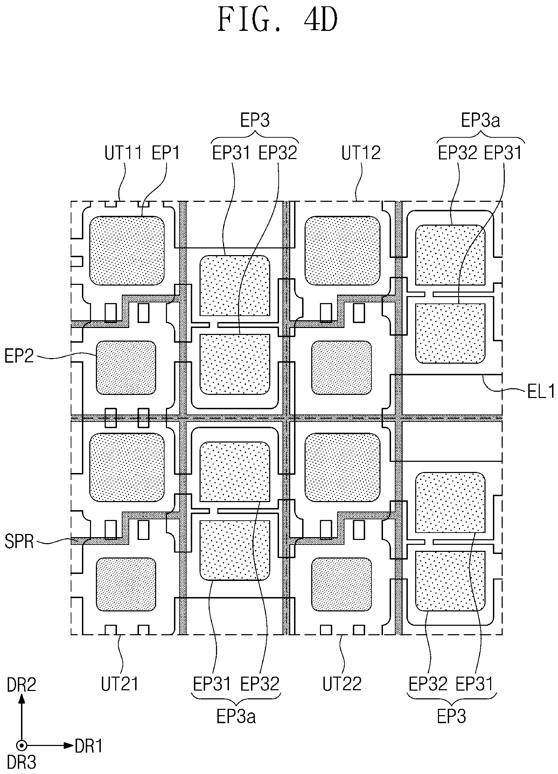

FIG. 4D illustrates the separator SPR, the light emitting parts EP1, EP2, and EP3, and the first electrode EL1.

Referring to FIG. 4D, the first electrode EL1 (hereinafter, an anode) of the light emitting element LD (e.g., see FIG. 5) according to an embodiment of the present disclosure may be commonly provided to the first to third light emitting parts EP1, EP2, and EP3. In other words, the anode EL1 may be provided as one layer that is entirely or substantially entirely integrated with the display area DA, and thus, the anode layer of the anode EL1 may be disposed to overlap with the separator SPR. As another example, the anode EL1 of each of the light emitting elements LD may be provided with a conductive pattern that is spaced apart from the others, and may be electrically connected to the others through another conductive layer. In this case, the anode EL1 may not overlap with the separator SPR.

As described above, the anode EL1 may be applied with the first power supply voltage VDD (e.g., see FIG. 2A), and all of the light emitting parts may be applied with a common voltage. The anode EL1 may also be connected with the first power line VDL (e.g., see FIG. 2A) through which the first power supplied voltage VDD is supplied in the peripheral area NDA, or may be connected with the first power line VDL in the display area DA, and the present disclosure is not limited to any particular embodiment.

A plurality of openings may be defined in the anode EL1 according to an embodiment, and the openings may penetrate through the anode layer of the anode EL1. The openings in the anode layer of the anode EL1 may be disposed at non-overlapping positions with the light emitting parts EP (e.g., see FIG. 3A), and may be defined at overlapping positions with the separator SPR. The openings may facilitate a discharge of a gas that may be generated from an organic layer disposed under the anode EL1, for example, such as form a sixth insulation layer 60 (e.g., see FIG. 5) to be described in more detail below. Accordingly, the gas from the organic layer disposed under the light emitting element may be sufficiently discharged in the process of manufacturing the display panel, and after manufacturing, the gas discharged from the organic layer may be reduced to decrease a rate of degradation of the light emitting element.

FIG. 5 is a cross-sectional view of the display panel DP according to an embodiment of the present disclosure. FIG. 5 illustrates a cross-section of a portion corresponding to the line I-I' in FIG. 4A.

Referring to FIG. 5, the display panel DP according to an embodiment may include a base layer BS, a driving element layer DDL, a light emitting element layer LDL, an encapsulation layer ECL, and a sensing layer ISL. However, the present disclosure is not limited thereto, and in an embodiment, the display panel DP may not include the sensing layer ISL.

The driving element layer DDL may include a plurality of insulation layers 10, 20, 30, 40, 50, and 60 disposed on the base layer BS, and a plurality of conductive patterns and semiconductor patterns disposed between the insulation layers 10, 20, 30, 40, 50, and 60. The conductive patterns and the semiconductor patterns may be disposed between the insulation layers 10, 20, 30, 40, 50, and 60 to constitute the pixel drivers PDC1 and PDC2. For convenience of illustration, FIG. 5 shows an example cross section of any one area from among the areas in which one light emitting part is disposed.

The base layer BS may be a member to provide a base surface on which the pixel drivers PDC1 and PDC2 are disposed. The base layer BS may be a rigid substrate, or a flexible substrate that is bendable, foldable, rollable, or the like. The base layer BS may be a glass substrate, a metal substrate, a polymer substrate, or the like. However, the present disclosure is not limited thereto, and the base layer BS may be an inorganic layer, an organic layer, or a composite material layer.

The base layer BS may have a multilayered structure. The base layer BS may include a first polymer resin layer, a silicon oxide (SiOx) layer disposed on the first polymer resin layer, an amorphous silicon (a-Si) layer disposed on the silicon oxide layer, and a second polymer resin layer disposed on the amorphous silicon layer. The silicon oxide layer and the amorphous silicon layer may be referred to as a base barrier layer.

The polymer resin layer may include a polyimide-based resin. In addition, the polymer resin layer may include at least one from among an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, or a perylene-based resin. As used herein, the expression "~~-based" resin means including a functional group of "-".

The insulation layers, the conductive layers, or the semiconductor layers disposed on the base layer BS may be provided in a suitable method such as coating, deposition, or the like. Then, through a plurality of photolithography processes, the insulation layers, the semiconductor layers, and the conductive layers may be selectively patterned to provide holes in the insulation layers, and/or to provide the semiconductor patterns, the conductive patterns, the signal lines, or the like.

The driving element layer DDL may include the first to sixth insulation layers 10, 20, 30, 40, 50, and 60 and the pixel drivers PDC1 and PDC2 that are sequentially laminated on the base layer BS. FIG. 5 illustrates examples of the first pixel driver PDC1 and second pixel driver PDC2 in FIGS. 4A and 4B. The first pixel driver PDC1 is shown as including one transistor TR1 and two capacitors C1 and C2, and the second pixel driver PDC2 is shown as including one transistor TR2. The transistor TR2 may be one of the plurality of transistors included in the second pixel driver PDC2.

The transistor TR1 of the first pixel driver PDC1 may correspond to the transistor that is connected to the light emitting element LD through an intermediate connection electrode CN and the connection electrode CNE, such as a connection transistor connected to a node (e.g., the fourth node N4 in FIG. 2A, the second node N2 in FIG. 2B, or the fourth node N4 in FIG. 2C) corresponding to the cathode of the light emitting element LD. For example, the transistor TR1 may correspond to the sixth transistor T6 in FIG. 2A, the first transistor T1 in FIG. 2B, or the fourth transistor T4a in FIG. 2C. Hereinafter, the transistor TR1 of the first pixel driver PDC1 may be referred to as the connection transistor. The light emitting element LD electrically connected to the first pixel driver PDC1 may be the first light emitting element LD1 (e.g., see FIG. 4C).

The second pixel driver PDC2 may be electrically connected to the second light emitting element LD2 (e.g., see FIG. 4C) adjacent to the first light emitting element LD1. For example, the second pixel driver PDC2 may be electrically connected to the second light emitting element LD2 through the intermediate connection electrode and the second connection electrode CNE2 (e.g., see FIG. 4C).

The other transistors constituting the pixel driver PDC1 or PDC2 may have the same or substantially the same structure as that of the transistor TR1 or TR2 in FIG. 5. However, the present disclosure is not limited thereto, and the other transistors constituting the pixel driver PDC1 or PDC2 may have a different structure from that of the transistor TR1 or TR2 in FIG. 5, and is not limited to any particular embodiment.

The first insulation layer 10 may be disposed on the base layer BS. The first insulation layer 10 may include an inorganic material and/or organic material, and may have a single layer structure or a multilayered structure. The first insulation layer 10 may include at least one among aluminium oxide, titanium oxide, silicon oxide, silicon oxynitride, zirconium oxide, and/or hafnium oxide. In an embodiment, the first insulation layer 10 is illustrated as a single silicon oxide layer in FIG. 5. The insulation layers to be described in more detail below may include an inorganic layer and/or organic layer, and have a single layer structure or a multilayered structure. The inorganic layer may include at least one of the aforementioned materials, but the present disclosure is not limited thereto.

The first insulation layer 10 may cover a bottom conductive layer BCL1 or BCL2. The display panel DP may further include the bottom conductive layer BCL1 or BCL2 disposed to overlap with the transistor TR1 or TR2. The bottom conductive layer BCL1 or BCL2 may block an electric potential caused by the polarization of the base layer BS from affecting the transistor TR1 or TR2. In addition, the bottom conductive layer BCL1 or BCL2 may block light from entering the transistor TR1 or TR2 from below. At least one of an inorganic barrier layer or a buffer layer may be further disposed between the bottom conductive layer BCL1 or BCL2 and the base layer BS.

The bottom conductive layer BCL1 or BCL2 may include a reflective metal. For example, the bottom conductive layer BCL1 or BCL2 may include titanium (Ti), molybdenum (Mo), an alloy containing molybdenum, aluminium (Al), an alloy containing aluminium, aluminium nitride (AIN), tungsten (W), tungsten nitride (WN), copper (CU), or the like.

The bottom conductive layer BCL1 or BCL2 may include the first bottom conductive layer BCL1 or the second bottom conductive layer BCL2. In an embodiment, the first bottom conductive layer BCL1 may be connected to a first source area SR1 of the connection transistor TR1 through a first source electrode pattern S1 (e.g., a (1-1)-th pattern). In this case, the first bottom conductive layer BCL1 may be synchronized with the first source area SR1 of the transistor TR1. The second bottom conductive layer BCL2 may be connected to a second source area SR2 of the connection transistor TR2 through a second source electrode pattern S2 (e.g., a (1-2)-th pattern). In this case, the second bottom conductive layer BCL2 may be synchronized with the second source area SR2 of the transistor TR2.

However, the present disclosure is not limited thereto, and the bottom conductive layer BCL1 or BCL2 may be connected and synchronized with the first gate electrode GE1 or second gate electrode GE2 of the transistor TR1 or TR2. As another example, the bottom conductive layer BCL1 or BCL2 may be connected to another electrode to be individually applied with an electrostatic voltage or a pulse signal. As another example, the bottom conductive layer BCL1 or BCL2 may be provided to be isolated from another conductive pattern. The bottom conductive layer BCL or BCL2 according to an embodiment may be provided in various suitable forms, and is not limited to any particular embodiment.

The transistor TR1 of the first pixel driver PDC1 and the transistor TR2 of the second pixel driver PDC2 may be disposed on the first insulation layer 10. The transistor TR1 of the first pixel driver PDC1 may include a first semiconductor pattern SP1 and a first gate electrode GE1. The transistor TR2 of the second pixel driver PDC2 may include a second semiconductor pattern SP2 and a second gate electrode GE2. The first and second semiconductor patterns SP1 and SP2 may be disposed on the first insulation layer 10. The first and second semiconductor patterns SP1 and SP2 may include a semiconductor oxide. For example, the oxide semiconductor may include a transparent conductive oxide (TCO), such as indium tin oxide (ITO), indium zinc oxide (IZO), indium gallium zinc oxide (IGZO), zinc oxide (ZnO), indium oxide (In₂O₃), or the like. However, the present disclosure is not limited thereto, and the first and second semiconductor patterns SP1 and SP2 may include amorphous silicon, a low-temperature polycrystalline silicon, or polycrystalline silicon.

Each of the first and second semiconductor patterns SP1 and SP2 may include a source area, a drain area, and a channel area divided according to a level of conductivity thereof. For example, the first semiconductor pattern SP1 may include a first source area SR1, a first drain area DR_1, and a first channel area CR1. The first source area SR1 and the first drain area DR_1 may be spaced apart from each other with the first channel area CR1 interposed therebetween. The first channel area CR1 may overlap with the first gate electrode GE1 in a plan view. The second semiconductor pattern SP2 may include a second source area SR2, a second drain area, and a second channel area CR2. The second source area SR2 and the second drain area may be spaced apart from each other with the second channel area CR2 interposed therebetween. The second channel area CR2 may overlap with the second gate electrode GE2 in a plan view. The line I-I' corresponding to the cross-sectional view of FIG. 5 does not pass through the second drain area of the second semiconductor pattern SP2, and thus, the second drain area is not shown in FIG. 5.

When the semiconductor pattern SP1 or SP2 is a semiconductor oxide, each of the source area SR1 or SR2 and the drain area DR_1 may be a reduced area. Accordingly, the source area SR1 or SR2 and the drain area DR_1 may have a relatively higher ratio of a content of a reduced metal. As another example, when the semiconductor pattern SP1 or SP2 is polycrystalline silicon, each of the source area SR1 or SR2 and the drain area DR_1 may be doped with a higher concentration.

The source area SR1 or SR2 and the drain area DR_1 may have a relatively higher conductivity than that of the channel area CR1 or CR2. The source area SR1 or SR2 may correspond to the source electrode of the transistor TR1 or TR2, and the drain area DR_1 may correspond to the drain electrode of the transistor TR1 or TR2. As shown in FIG. 5, a separate source electrode pattern S1 or S2 and drain electrode pattern D1 or D2 may be further included to be respectively connected to the source area SR1 or SR2 and the drain area DR_1. In more detail, the separate source electrode pattern S1 or S2 and drain electrode pattern D1 or D2 may be integrally provided with a respective one of lines constituting the pixel driver (e.g., see PDC in FIG. 2A, PDC-1 in FIG. 2B, or PDC-2 in FIG. 2C), and are not limited to any particular embodiment.

The second insulation layer 20 may commonly overlap with a plurality of pixels, and may cover the semiconductor pattern SP1 or SP2. The second insulation layer 20 may include an inorganic layer and/or an organic layer, and may have a single layer structure or a multilayered structure. The second insulation layer 20 may include at least one among aluminium oxide, titanium oxide, silicon oxide, silicon nitride, silicon oxynitride, zirconium oxide, or hafnium oxide. In the present embodiment, the second insulation layer 20 may be a single silicon oxide layer.

The gate electrodes GE1 and GE2 may be disposed on the second insulation layer 20. The first gate electrode GE1 may correspond to a gate of the transistor TR1 of the first pixel driver PDC1, and the second gate electrode GE2 may correspond to a gate of the transistor TR2 of the second pixel driver PDC2. Each of the gate electrodes GE1 and GE2 may be disposed above the semiconductor patterns SP1 and SP2. However, the present disclosure is not limited thereto, and the gate electrodes GE1 and GE2 may be disposed under the semiconductor patterns SP1 and SP2, respectively, and are not limited to any particular embodiment.

Each of the gate electrodes GE1 and GE2 may include titanium (Ti), silver (Ag), molybdenum (Mo), aluminium (Al), aluminium nitride (AIN), tungsten (W), tungsten nitride (WN), copper (Cu), a suitable alloy thereof, or the like, but the present disclosure is not particularly limited thereto.

The third insulation layer 30 may be disposed on the gate electrodes GE1 and GE2. The third insulation layer 30 may include an inorganic layer and/or an organic layer, and have a single layer structure or a multilayered structure. The fourth insulation layer 40 may include at least one among aluminium oxide, titanium oxide, silicon oxide, silicon nitride, silicon oxynitride, zirconium oxide, or hafnium oxide.

A first capacitor electrode CPE1 and a second capacitor electrode CPE2 from among the plurality of conductive patterns S1, S2, D1, CPE1, CPE2, and CPE3 provide the first capacitor C1. The first capacitor electrode CPE1 and the second capacitor electrode CPE2 may be spaced apart from each other with the first insulation layer 10 and the second insulation layer 20 interposed therebetween.

In an embodiment of the present disclosure, the first capacitor electrode CPE1 and the first bottom conductive layer BCL1 may have an integral shape. In addition, the second capacitor electrode CPE2 may have a mutually connected integral shape with the first gate electrode GE1, and the capacitor electrode CPE may have a mutually connected integral shape with the second gate electrode GE2. However, the present disclosure is not limited thereto. For example, the first capacitor electrode CPE1 and the first bottom conductive layer BCL1 may be disposed at (e.g., in or on) the same layer as each other, and may be spaced apart from each other. The second capacitor electrode CPE2 and the first gate electrode GE1 may be disposed at (e.g., in or on) the same layer as each other, and may be spaced apart from each other. The capacitor electrode CPE and the second gate electrode GE2 may be disposed at (e.g., in or on) the same layer as each other, and may be spaced apart from each other.

A third capacitor electrode CPE3 may be disposed on the third insulation layer 30. The third capacitor electrode CPE3 may be spaced apart from the second capacitor electrode CPE2 with the third insulation layer 30 interposed therebetween. The third capacitor electrode CPE3 and the second capacitor CPE2 may provide the second capacitor C2.

The fourth insulation layer 40 may be disposed on the third insulation layer 30 and/or the third capacitor electrode CPE3. The fourth insulation layer 40 may include an inorganic material and/or an organic material, and may have a single layer structure or a multilayered structure. The fourth insulation layer 40 may include at least one among aluminium oxide, titanium oxide, silicon oxide, silicon nitride, silicon oxynitride, zirconium oxide, or hafnium oxide.

On the fourth insulation layer 40, the first source electrode pattern S1 and the first drain electrode pattern D1 connected with the first semiconductor pattern SP1, and the second source electrode pattern S2 and the second drain electrode pattern D2 connected with the second semiconductor pattern SP2 may be disposed.

The first source electrode pattern S1 may be connected to the first source area SR1 of the connection transistor TR1 through a first contact hole CNT1, and the first source electrode pattern S1 and the first source area SR1 of the first semiconductor pattern SP1 may function as the source of the connection transistor TR1. The first drain electrode pattern D1 may be connected to the drain area DR_1 of the connection transistor TR1 through a second contact hole CNT2, and the first drain electrode pattern D1 and the drain area DR_1 of the first semiconductor pattern SP1 may function as the drain of the connection transistor TR1.

The second source electrode pattern S2 may be connected, through a contact hole, to the second bottom conductive layer BCL2 and the second source area SR2 of the transistor TR2 of the second pixel driver PDC2. The second source electrode pattern S2 and the second source area SR2 of the second semiconductor pattern SP2 may function as the source of the transistor TR2. The second drain electrode pattern D2 may be connected to the second gate electrode GE2 through a contact hole, and the second gate electrode GE2 may be connected to the second drain area of the second semiconductor pattern SP2. The second drain electrode pattern D2 may be connected to the second drain area of the transistor TR2, and the second drain electrode pattern D2 and the second drain area may function as the drain of the transistor TR2.

The fifth insulation layer 50 may be disposed on the first source electrode pattern S1, the first drain electrode pattern D1, the second source electrode pattern S2, and the second drain electrode pattern D2.

The intermediate connection electrode CN may be disposed on the fifth insulation layer 50. The intermediate connection electrode CN may electrically connect the first pixel driver PDC1 and the connection electrode CNE to each other. The intermediate connection electrode CN may electrically connect the light emitting element LD and the connection transistor TR1 of the connection transistor TR1 of the first pixel driver PDC1 to each other. The intermediate connection electrode CN may be a connection node that connects the first pixel driver PDC1 and the light emitting element LD to each other. The intermediate connection electrode CN may correspond to the fourth node N4 (e.g., see FIG. 2A), the second node N2 (e.g., see FIG. 2B), or the fourth node N4 (e.g., see FIG. 2C).

The sixth insulation layer 60 may be disposed on the intermediate connection electrode CN. The sixth insulation layer 60 may be disposed on the fifth insulation layer 50 to cover at least a portion of the intermediate connection electrode CN. Each of the fifth insulation layer 50 and the sixth insulation layer 60 may be an organic layer. For example, each of the fifth and sixth insulation layers 50 and 60 may include a general purpose polymer, such as Benzocyclobutene (BCB), polyimide, Hexamethyldisiloxane (HMDSO), Polymethylmethacrylate (PMMA), or Polystyrene (PS), a polymer derivative having a phenol-based group, an acryl-based polymer, an imide-based polymer, an allyl ether-based polymer, an amide-based polymer, a fluorine-based polymer, a p-xylene-based polymer, a vinylalcohol-based polymer, or a suitable blend thereof.

A through-hole OP-60 exposing at least a portion of the intermediate connection electrode CN may be provided in the sixth insulation layer 60. The intermediate connection electrode CN may be connected to the connection electrode CNE through the exposed portion from the sixth insulation layer 60, and may be electrically connected to the light emitting element LD. The intermediate connection electrode CN may electrically connect, together with the connection electrode CNE, the connection transistor TR1 and the light emitting element LD to each other. In the display panel DP according to an embodiment of the present disclosure, the sixth insulation layer 60 may be omitted or provided in a plurality as needed or desired, and thus, is not limited to any particular embodiment. When the sixth insulation layer 60 is omitted, the intermediate connection electrode CN may also be omitted.

The intermediate connection electrode CN may include a first layer L1, a second layer L2, and a third layer L3 that are sequentially laminated along the third direction DR3. The second layer L2 may include a different material from that of the first layer L1. In addition, the second layer L2 may include a different material from that of the third layer L3. The second layer L2 may have a relatively thicker thickness than that of the first layer L1. In addition, the second layer L2 may have a relatively thicker thickness than that of the third layer L3. The second layer L2 may include a suitable material having a high conductivity. In an embodiment, the second layer L2 may include aluminium (Al).

The light emitting element layer LDL may be disposed on the driving element layer DDL. The light emitting element layer LDL may include the pixel definition layer PDL, the light emitting element LD, and the separator SPR.

The pixel definition layer PDL may be an organic layer. For example, the pixel definition layer PDL may include a general purpose polymer, such as Benzocyclobutene (BCB), polyimide, Hexamethyldisiloxane (HMDSO), PMMA, or PS, a polymer derivative having a phenol-based group, an acryl-based polymer, an imide-based polymer, an allyl ether-based polymer, an amide-based polymer, a fluorine-based polymer, a p-xylene-based polymer, a vinylalcohol-based polymer, or a suitable blend thereof.

In an embodiment, the pixel definition layer PDL may have a light absorption property, and, for example, may have a black color. In other words, the pixel definition layer PDL may include a black coloring agent. The black coloring agent may include a black dye or a black pigment. The black coloring agent may include carbon black, a metal such as chromium, or an oxide thereof. The pixel definition layer PDL may correspond to a light blocking pattern having light blocking characteristics.

The opening OP-PDL (hereinafter, an emission opening) exposing at least a portion of the first electrode EL1 to be described in more detail below may be defined in the pixel definition layer PDL. The emission opening OP-PDL may be provided in a plurality to be disposed in correspondence to the light emitting elements, respectively. The emission opening OP-PDL may be an area overlapping with all of the components of the light emitting element LD, and at which light emitted from the light emitting element LD is displayed or substantially displayed. Accordingly, the shape of the first light emitting part EP1 (e.g., see FIG. 4A) may correspond to or substantially correspond to that of the emission opening OP-PDL in a plan view.

The connection electrode CNE may be disposed on the pixel definition layer PDL. The connection electrode CNE may electrically connect the pixel driver PDC and the light emitting element LD to each other. The pixel driver PDC may be electrically connected to the light emitting element LD via the intermediate connection electrode CN and the connection electrode CNE. The connection electrode CNE may correspond to the first connection electrode CNE1 in FIG. 4A. The second connection electrode CNE2 (e.g., see FIG. 4A) and the third connection electrode CNE3 (e.g., see FIG. 4A) may also have the structure similar to or the same as that of the connection electrode CNE.

The connection electrode CNE may include a first edge EG1c adjacent to (e.g., facing) the emission opening OP-PDL, and the second edge EG2c surrounding (e.g., around a periphery of) the first edge EG1c. The second electrode EL2 of the light emitting element LD may contact the connection electrode CNE in an area adjacent to the second edge EG2c.

The connection electrode CNE may include a transparent conductive oxide (TCO), such as indium tin oxide (ITO), indium zinc oxide (IZO), indium gallium zinc oxide (IGZO), zinc oxide (ZnO), indium oxide In₂O₃, or the like. However, the material of the connection electrode CNE is not limited thereto.

A through-hole OP-P spaced apart from the emission opening OP-PDL may be defined in the pixel definition layer PDL. The emission opening OP-PDL may be provided in a plurality, each of which may correspond to one of the light emitting elements LD. The size of the through hole OP-P defined in the pixel definition layer PDL may be greater than that of the through-hole OP-60 defined in the sixth insulation layer 60. The connection electrode CNE may be disposed in the through hole OP-P and the through-hole OP-60, and may be connected to the intermediate connection electrode CN.

The light emitting element LD may include the first electrode EL1, an intermediate layer IML, and the second electrode EL2.

The first electrode EL1 may be a semi-transmissive, transmissive, or reflective electrode. According to an embodiment of the present disclosure, the first electrode EL1 may include a reflective layer including (e.g., composed of) silver (Ag), magnesium (Mg), aluminium (Al), platinum (Pt), palladium (Pd), gold (Au), nickel (Ni), neodymium (Nd), iridium (Ir), chromium (Cr), a suitable compound thereof, or the like, and a transparent or semi-transparent electrode layer provided on the reflective layer. The transparent or semi-transparent electrode layer may include at least one selected from the group consisting of indium tin oxide (ITO), indium zinc oxide (IZO), indium gallium zinc oxide (IGZO), zinc oxide (ZnO), indium oxide (In₂O₃), and aluminium-doped zinc oxide (AZO). For example, the first electrode EL1 may include a laminate structure of ITO/Ag/ITO.

In the present embodiment, the first electrode EL1 may be the anode of the light emitting element LD. In other words, the first electrode EL1 may be connected with the first power line VDL (e.g., see FIG. 2A), and may be applied with the first power supply voltage VDD. The first electrode EL1 may be connected to the first power line VDL in the display area DA (e.g., see FIGS. 3A or 3B), or to the first power line VDL in the peripheral area NDA. In the latter case, the first power line VDL may be disposed in the peripheral area NDA, and the first electrode EL1 may have a shape extending to the peripheral area NDA.

In the cross-sectional view in FIG. 5, the first electrode EL1 is shown as overlapping with the emission opening OP-PDL and not overlapping with the separator SPR, but as shown in FIG. 4D, the first electrodes EL1 of the light emitting elements may have an integral shape, and may have a mesh or lattice shape in which the openings are defined in a partial area. In other words, when the first power supply voltage VDD is applied to the first electrodes EL1 of the plurality of light emitting elements, the shape of each of the first electrodes EL1 may be provided in various suitable manners, and is not limited to any particular embodiment.

The intermediate layer IML may be disposed between the first electrode EL1 and the second electrode EL2. The intermediate layer IML may include the light emitting layer EML and a function layer FNL. The light emitting element LD may include the intermediate layer IML having various suitable structures, and is not limited to any particular embodiment. For example, the functional layer FNL may be provided in a plurality, and may include two or more layers spaced apart from each other with the light emitting layer EML interposed therebetween.

The light emitting layer EML may include an organic emission material. In addition, the light emitting layer EML may include an inorganic emission material, or may be provided with a mixture layer of an organic emission material and an inorganic emission material. In the present embodiment, the light emitting layer EML included in the adjacent light emitting parts EP (e.g., see FIG. 3A) may include emission materials for displaying different colors from each other. For example, the light emitting layer EML included in each of the light emitting parts EP may provide light of any one color from among blue, red, or green. However, the present disclosure is not limited thereto, and the light emitting layer EML in all of the light emitting parts EP may have the emission material for displaying light of the same color as each other. In this case, the light emitting layer EML may provide blue light or white light.

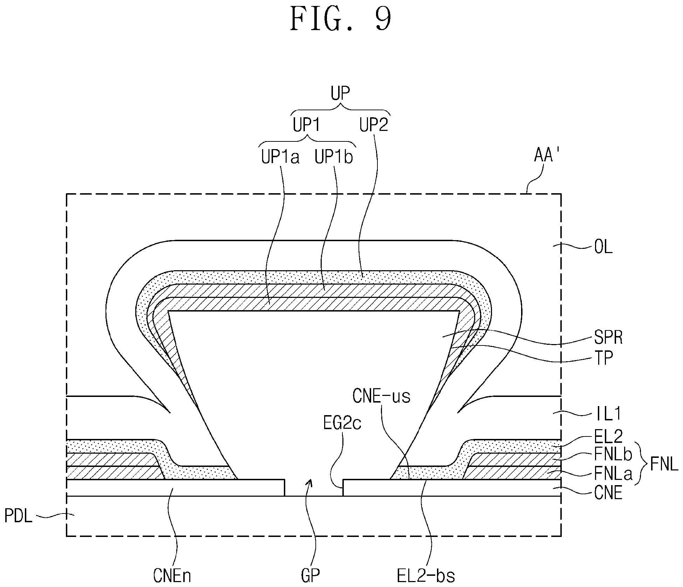

The functional layer FNL may be disposed between the first electrode EL1 and the second electrode EL2. In more detail, the functional layer FNL may include a first intermediate functional layer FNLa (e.g., see FIG. 9) disposed between the first electrode EL1 and the light emitting layer EML and a second intermediate functional layer FNLb disposed between the second electrode EL2 and the light emitting layer EML. In an embodiment of the present disclosure, one of the first intermediate functional layer FNLa or the second intermediate functional layer FNLb may be omitted as needed or desired. In the present embodiment, the light emitting layer EML is shown as being inserted into the functional layer FNL. For example, it may be understood that the light emitting layer EML is disposed between the first intermediate functional layer FNLa and the second intermediate functional layer FNLb.

The functional layer FNL may control a charge transfer between the first electrode EL1 and the second electrode EL2. For example, the first intermediate functional layer FNLa may include one or more hole injection/transport materials and/or one or more electron injection/transport materials. The second intermediate functional layer FNLb may include at least one among an electron blocking layer, a hole transport layer, a hole injection layer, a hole blocking layer, an electron transport layer, an electron injection layer, or a charge generation layer.

The second electrode EL2 may be disposed on the intermediate layer IML. As described above, the second electrode EL2 may be connected to the connection electrode CNE to be electrically connected to the first pixel driver PDC1. The second electrode EL2 may be electrically connected to the connection transistor TR1 through the connection electrode CNE.

The separator SPR may be disposed on the pixel definition layer PDL. In addition, the separator SPR may be disposed on a gap GP (e.g., see FIG. 9) between the connection electrode CNE on the pixel definition layer PDL and an adjacent connection electrode CNEn adjacent to the connection electrode CNE.

In an embodiment, the second electrode EL2 and the functional layer FNL may be commonly deposited on the plurality of pixels through an open mask. Here, the second electrode EL2 and the functional layer FNL may be divided by the separator SPR. As described above, the separator SPR may have a closed line shape for each of the light emitting parts, and thus, the second electrode EL2 and the functional layer FNL may have a divided shape for each of the light emitting parts. In other words, the second electrode EL2 and the intermediate layer IML may be electrically isolated from each adjacent pixel. The separator will be described in more detail below with reference to FIG. 9.

The encapsulation layer ECL may be disposed on the light emitting element layer LDL. The encapsulation layer ECL may cover the light emitting element LD and the separator SPR. The encapsulation layer ECL may include a first inorganic layer IL1, an organic layer OL, and a second inorganic layer IL2, which are sequentially laminated. However, the present disclosure is not limited thereto, and the encapsulation layer ECL may further include a plurality of inorganic layers and organic layers. The encapsulation layer ECL may be a glass substrate.

The first and second inorganic layers IL1 and IL2 may protect the light emitting element LD from the moisture and oxygen from outside the display panel DP, and the organic layer OL may protect the light emitting element LD from foreign matters, such as particles, which may remain in a process of providing the first inorganic layer IL1. The first and second inorganic layers IL1 and IL2 may include a silicon nitride layer, a silicon oxynitride layer, a silicon oxide layer, a titanium oxide layer, an aluminium oxide layer, or the like. The organic layer OL may include an acrylic-based organic layer, but the present disclosure is not limited to the material thereof.

The sensing layer ISL may sense an external input. In an embodiment, the sensing layer ISL may be provided on the encapsulation layer ECL through consecutive processes. In this case, the sensing layer ISL may be understood as being directly disposed on the encapsulation layer ECL. As used herein, "directly disposed" may mean that another component is not disposed between the sensing layer ISL and the encapsulation layer ECL. In other words, a separate adhesive member may not be disposed between the sensing layer ISL and the encapsulation layer ECL. However, the present disclosure is not limited thereto. In the display panel DP according to an embodiment of the present disclosure, the sensing layer ISL may be separately provided, and then may be combined with the display panel DP through an adhesive member, but the present disclosure is not limited to any particular embodiment.

The sensing layer ISL may include a plurality of conductive layers and a plurality of insulation layers. The plurality of conductive layers may include a first sensing conductive layer MTL1 and a second sensing conductive layer MTL2. The plurality of insulation layers may include first to third sensing insulation layers 71, 72, and 73. However, the present disclosure is not limited thereto, and the numbers of the conductive layers and the insulation layers are not limited to any particular embodiment.

Each of the first to third sensing insulation layers 71, 72, and 73 may have a single layer structure, or a multi-layered structure laminated along the third direction DR3. Each of the first to third sensing insulation layers 71, 72, and 73 may include an inorganic film. The inorganic film may include at least one among aluminium oxide, titanium oxide, silicon oxide, silicon nitride, silicon oxynitride, zirconium oxide, or hafnium oxide. Each of the first to third sensing insulation layers 71, 72, and 73 may include an organic film. The organic film may include at least one among an acrylic-based resin, a methacrylic-based resin, polyisoprene, a vinyl-based resin, an epoxy-based resin, a urethane-based resin, a cellulose-based resin, a siloxane-based resin, a polyimide based-resin, a polyamide-resin, or a parylene-based resin.

The first sensing conductive layer MTL1 may be disposed between the first sensing insulation layer 71 and the second sensing insulation layer 72, and the second sensing conductive layer MTL2 may be disposed between the second sensing insulation layer 72 and the third sensing insulation layer 73. A portion of the second sensing conductive layer MTL2 may be connected to the first sensing conductive layer MTL1 through a contact hole CNT provided in the second sensing insulation layer 72. The first sensing conductive layer MTL1 and the second sensing conductive layer MTL2 may each have a single layer structure, or a multilayered structure laminated along the third direction DR3.

A sensing conductive layer of the single layer structure may include a metal layer or a transparent conductive layer. The metal layer may include molybdenum, silver, titanium, copper, aluminium, or a suitable alloy thereof. The transparent conductive layer may include a transparent conductive oxide, such as indium tin oxide (ITO), indium zinc oxide (IZO), zinc oxide (ZnO), indium zinc tin oxide (IZTO), or the like. As another example, the transparent conductive layer may include a conductive polymer such as PEDOT, a metal nano-wire, graphene, or the like.

A sensing conductive layer of the multilayered structure may include a plurality of metal layers. For example, the metal layers may have a three-layered structure of titanium/aluminium/titanium. As another example, the sensing conductive layer of the multilayered structure may include at least one metal layer and at least one transparent conductive layer.

The first sensing conductive layer MTL1 and the second sensing conductive layer MTL2 may constitute a sensor to sense an external input in the sensing layer ISL. The sensor may be driven in an electrostatic capacitance mode, and in more detail, may be driven in any one of a mutual-cap mode or a self-cap mode. However, the present disclosure is not limited thereto. Besides the electrostatic capacitance mode, the sensor may be driven in a resistance film mode, an ultrasonic mode, or an infrared mode, and is not limited to any particular embodiment.

Each of the first sensing conductive layer MTL1 and the second sensing conductive layer MTL2 may also include a transparent conductive oxide, or may have the shape of a metal mesh including (e.g., composed of) non-transparent conductive materials. When visibility of an image displayed on the display panel DP is not reduced, each of the first sensing conductive layer MTL1 and the second sensing conductive layer MTL2 may include various suitable materials and various suitable shapes, and is not limited to any particular embodiment.

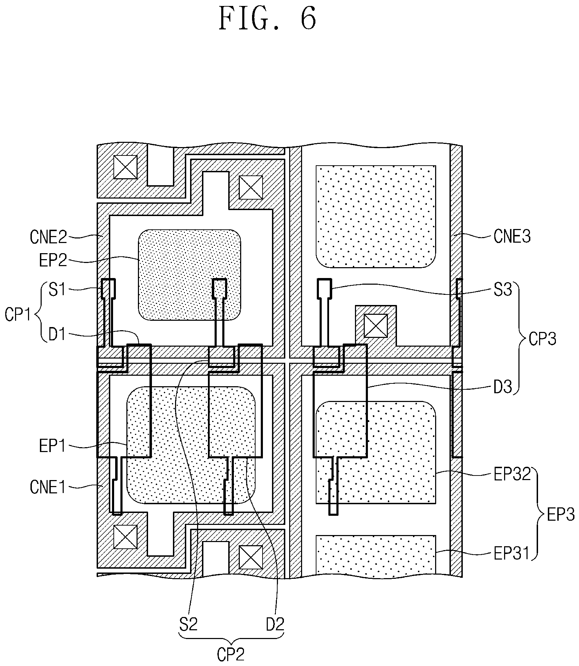

FIG. 6 is an enlarged plan view of a partial area of a display panel according to an embodiment of the present disclosure. FIG. 6 is a schematic view illustrating some components (e.g., the connection electrodes CNE1, CNE2, and CNE3, and the light emitting parts EP1, EP2, and EP3), and first to third conductive patterns CP1, CP2, and CP3.

Referring to FIGS. 5 and 6, the display panel DP may include the first to third pixel drivers PDC1, PDC2, and PDC3 (e.g., see FIG. 4B). The first pixel driver PDC1 may include the first conductive pattern CP1, the second pixel driver PDC2 may include the second conductive pattern CP2, and the third pixel driver PDC3 may include the third conductive pattern CP3.

The first conductive pattern CP1 may include a (1-1)-th pattern S1, and a (2-1)-th pattern D1 electrically connected to the first connection electrode CNE1. The second conductive pattern CP2 may include a (1-2)-th pattern S2, and a (2-2)-th pattern D2 electrically connected to the second connection electrode CNE2. The third conductive pattern CP3 may include a (1-3)-th pattern S3, and a (2-3)-th pattern D3 electrically connected to the third connection electrode CNE3. The (1-1)-th, (1-2)-th and (1-3)-th patterns S1, S2, and S3 may correspond to a source electrode pattern of a transistor, and the (2-1)-th, (2-2)-th, and (2-3)-th patterns D1, D2, and D3 may correspond to a drain electrode pattern of the transistor.

The conductive patterns CP1, CP2, and CP3 may overlap with the adjacent connection electrodes CNE1, CNE2, and CNE3 that are not electrically connected thereto. For example, the (1-1)-th and (2-1)-th patterns S1 and D1 of the first conductive pattern CP1 are not electrically connected to the second connection electrode CNE2, but may overlap with the second connection electrode CNE2 in a plan view. The (1-2)-th and (2-2)-th patterns S2 and D2 of the second conductive pattern CP2 are not electrically connected to the first connection electrode CNE1, but may overlap with the first connection electrode CNE1 in a plan view. As the conductive patterns that are not electrically connected to the connection electrodes overlap with the connection electrodes in a plan view, an electric field may vary, and a coupling noise may be generated or increased in response to the variation of the electric field.

Referring again to FIG. 5, the display panel DP may further include a first metal layer ML1. The first metal layer ML1 may include the same material as that of, and connected to, the first electrode EL1. The first metal layer ML1 may be provided in the same process as that of the first electrode EL1. The first metal layer ML1 may be disposed between the connection electrode CNE and the (1-2)-th pattern S2 and the (2-2)-th pattern D2 in a cross-sectional view. The (1-2)-th pattern S2 and the (2-2)-th pattern D2 of the second conductive pattern CP2 may overlap with the first metal layer ML1 in a plan view.

The connection electrode CNE in FIG. 5 may not be electrically connected with the (1-2)-th pattern S2 and the (2-2)-th pattern D2. For example, referring to FIG. 6, the first metal layer ML1 may include the same material as that of, and connected to, the first electrode EL1 of the first light emitting part EP1. The first metal layer ML1 may be disposed between the second conductive pattern CP2 and the first connection electrode CNE1 in a cross-sectional view, and may overlap with the (1-2)-th and (2-2)-th patterns S2 and D2 of the second conductive pattern CP2 in a plan view.

However, the present disclosure is not limited thereto, and the position of the first metal layer ML1 may be variously modified as needed or desired. For example, the first metal layer ML1 may be disposed between the first conductive pattern CP1 and the second connection electrode CNE2 in a cross-sectional view, and may overlap with the (1-1)-th and (2-1)-th patterns S1 and D1 of the first conductive pattern CP1 in a plan view.

According to an embodiment of the present disclosure, the first electrode EL1 of the display panel DP may extend to be disposed between the connection electrode CNE and the conductive patterns CP1, CP2, and CP3. The first electrode EL1 may be provided with the first power supply voltage VDD (e.g., see FIG. 2A). As the conductive patterns CP1, CP2, and CP3 and the connection electrode CNE are shielded using the first electrode EL1 provided with a constant voltage, a coupling noise generated therebetween may be reduced or removed.

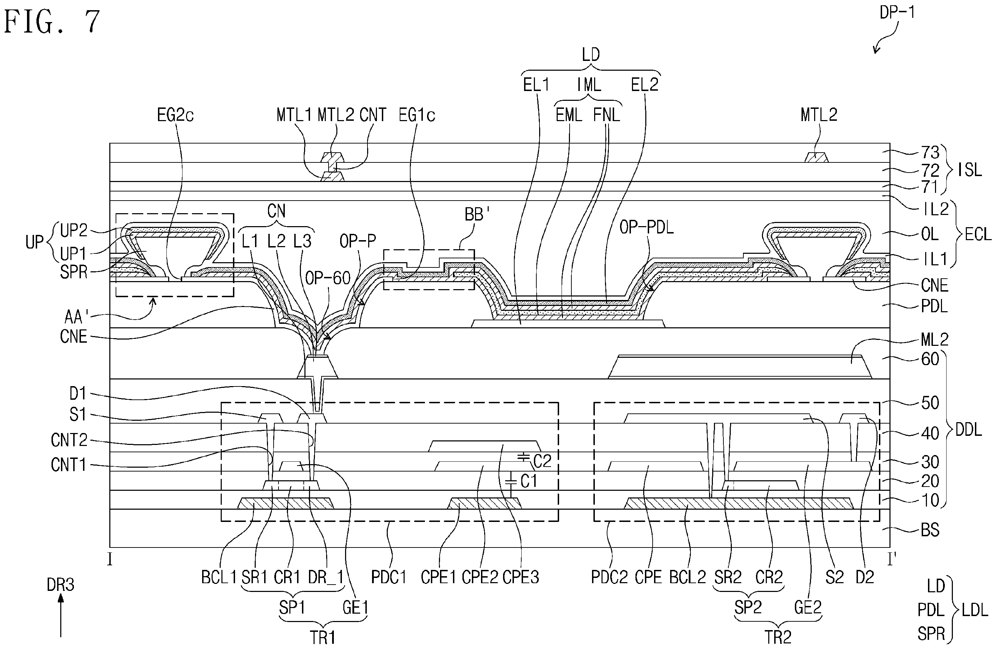

FIG. 7 is a cross-sectional view of a display panel DP-1 according to an embodiment of the present disclosure. FIG. 7 illustrates a cross-section of a portion corresponding to the line I-I' in FIG. 4A. In FIG. 7, like reference numerals are used to denote like elements (e.g., the same or substantially the same elements) as those described above with reference to FIG. 5, and thus, redundant description thereof may not be repeated.

Referring to FIG. 7, the display panel DP-1 may include a second metal layer ML2. The second metal layer ML2 may include the same material as that of, and may be disposed at (e.g., in or on) the same layer as that of, the intermediate connection electrode CN. The second metal layer ML2 may be provided in the same process as that of the intermediate connection electrode CN. The second metal layer ML2 may be disposed between the connection electrode CNE and the (1-2)-th and (2-2)-th patterns S2 and D2. The (1-2)-th and (2-2)-th patterns S2 and D2 may overlap with the second metal layer ML2 in a plan view.

The connection electrode CNE in FIG. 7 may not be electrically connected with the (1-2)-th and (2-2)-th patterns S2 and D2. For example, referring to FIG. 6, the second metal layer ML2 may include the same material as that of, and may be disposed at (e.g., in or on) the same layer as that of, the intermediate connection electrode CN that electrically connects the first pixel driving part PDC1 and the first connection electrode CNE1 to each other. The second metal layer ML2 may be disposed between the second conductive pattern CP2 and the first connection electrode CNE1 in a cross-section view, and may overlap with the (1-2)-th and (2-2)-th patterns S2 and D2 of the second conductive pattern CP2 in a plan view.

However, the present disclosure is not limited thereto, and the position of the second metal layer ML2 may be variously modified as needed or desired. For example, the second metal layer ML2 may be disposed between the first conductive pattern CP1 and the second connection electrode CNE2 in a cross-sectional view, and may overlap with the (1-1)-th and (2-1)-th patterns S1 and D1 in a plan view.

According to some embodiments of the present disclosure, the intermediate connection electrode CN of the display panel DP-1 may extend to reduce or remove a coupling noise provided between the connection electrode CNE and the conductive patterns CP1, CP2, and CP3.

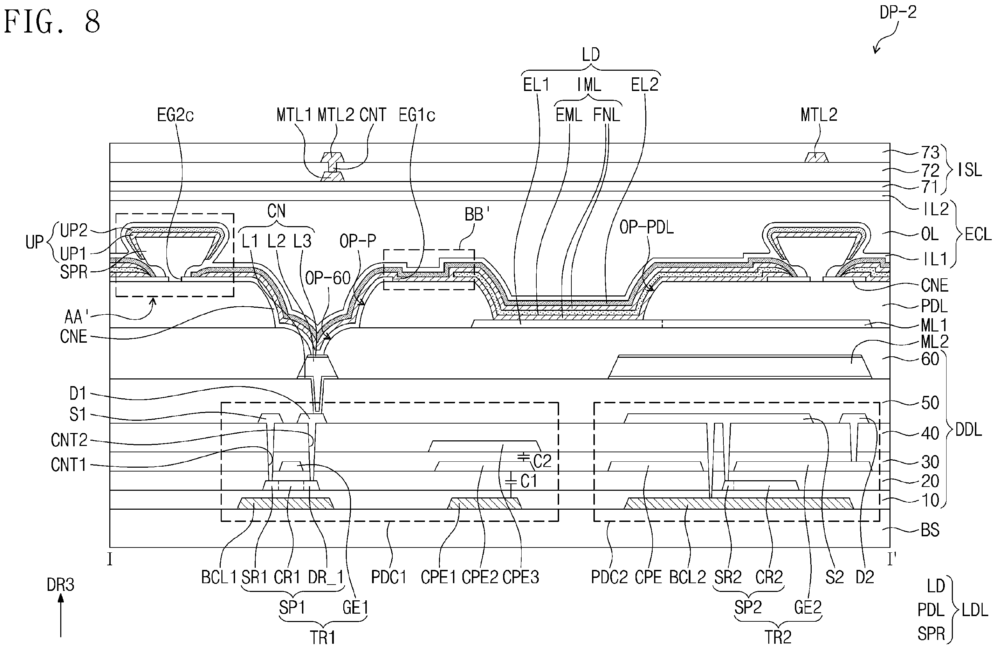

FIG. 8 is a cross-sectional view of a display panel DP-2 according to an embodiment of the present disclosure. FIG. 8 illustrates a cross-section of a portion corresponding to the line I-I' in FIG. 4A. In FIG. 8, like reference numerals are used to denote like elements (e.g., the same or substantially the same elements) as those described above with reference to FIG. 5, and thus, redundant description thereof may not be repeated.

Referring to FIG. 8, the display panel DP-2 may include both the first metal layer ML1 and the second metal layer ML2. The first metal layer ML1 may include the same material as that of, and connected to, the first electrode EL1. The second metal layer ML2 may include the same material as that of, and may be disposed at (e.g., in or on) the same layer as that of, the intermediate connection electrode CN. The first metal layer ML1 may be provided in the same process as that of the first electrode EL1, and the second metal layer ML2 may be provided in the same process as that of the intermediate connection electrode CN.

The first and second metal layers ML1 and ML2 may be disposed between the connection electrode CNE and the (1-2)-th and (2-2)-th patterns S2 and D2. The (1-2)-th and (2-2)-th patterns S2 and D2 may overlap with the first and second metal layers ML1 and ML2 in a plan view.

The connection electrode CNE in FIG. 8 may not be electrically connected with the (1-2)-th and (2-2)-th patterns S2 and D2. For example, referring to FIG. 6, the first metal layer ML1 may include the same material as that of, and connected to, the first electrode EL1 of the first light emitting part EP1. The second metal layer ML2 may include the same material as that of, and may be disposed at (e.g., in or on) the same layer as that of, the intermediate connection electrode CN that electrically connects the first pixel driver PDC1 and the first connection electrode CNE1 to each other. The first and second metal layers ML1 and ML2 may be disposed between the second conductive pattern CP2 and the first connection electrode CNE1 in a cross-sectional view, and may overlap with the (1-2)-th and (2-2)-th patterns S2 and D2 in a plan view.

However, the present disclosure is not limited thereto, and the positions of the first and second metal layers ML1 and ML2 may be variously modified as needed or desired. For example, the first and second metal layers ML1 and ML2 may be disposed between the first conductive pattern CP1 and the second connection electrode CNE2 in a cross-sectional view, and may overlap with the (1-1)-th and (2-1)-th patterns S1 and D1 in a plan view.

According to an embodiment of the present disclosure, the intermediate connection electrode CN and/or the first electrode EL1 of the display panel DP-2 may extend to reduce or remove a coupling noise provided between the conductive patterns CP1, CP2, and CP3 and the connection electrode CNE.

FIG. 9 is an enlarged cross-sectional view of a partial area of the display panel DP according to an embodiment of the present disclosure. FIG. 9 is an enlarged plan view of the area AA' in FIG. 5.

Referring to FIGS. 5 and 9, in an embodiment, the separator SPR may have a reverse tapered shape. For example, the farther away the separator SPR is from the top surface of the pixel definition layer PDL, the wider the width thereof. A side surface TP of the separator SPR may have a shape in which a taper angle from the top surface of the pixel definition layer PDL is obtuse. However, the present disclosure is not limited thereto, and when the separator SPR electrically disconnects the second electrode EL2 for each of the pixels, the separator SPR may have a double structure in which the taper angle may be variously modified, for example, such that the taper angle varies. In addition, the separator SPR may have the same or substantially the same structure as that of a tip part, and is not limited to any particular embodiment.

The separator SPR may include a suitable material having an insulation property, for example, such as an organic insulation material. The separator SPR may also include an inorganic insulation material, or a multilayered structure of organic and inorganic insulation materials, and in some embodiments, may also include a conductive material. When the second electrode EL2 is electrically disconnected for each of the pixels, the separator SPR is not particularly limited to any particular kind of material.

On the separator SPR, a dummy layer UP may be provided. The dummy layer UP may include a first dummy layer UP1 disposed on the separator SPR, and a second dummy layer UP2 disposed on the first dummy layer UP1. The first dummy layer UP1 may be provided in the same process as that of, and include the same material as that of, the intermediate layer IML. The first dummy layer UP1 may include a (1-1)-th dummy layer UP1a and a (1-2)-th dummy layer UP1b. The (1-1)-th dummy layer UP1a may be provided in the same process as that of, and may include the same material as that of, the first intermediate functional layer FNL1a. The (1-2)-th dummy layer UP1b may be provided in the same process as that of, and may include the same material as that of, the second intermediate functional layer FNLb. The second dummy layer UP2 may be provided in the same process as that of, and may include the same material as that of, the second electrode EL2. In other words, the first and second dummy layers UP1 and UP2 may be concurrently provided in the manufacturing process as those of the functional layer FNL and the second electrode EL2. As shown in FIG. 9, the dummy layer UP may also be provided on a portion of the side surface TP, as well as on the top surface of the separator SPR. In another embodiment, the display panel DP may not include the dummy layer UP. The dummy layer UP may not contact the connection electrode CNE and the second electrode EL2. The second dummy layer UP2 included in the dummy layer UP may not contact the connection electrode CNE and the second electrode EL2.

A portion in which the second electrode EL2 contacts the connection electrode CNE may be defined as a contact area. The contact area may be provided adjacent to the separator SPR. In the contact area, the top surface CNE-us of the connection electrode CNE contacts the bottom surface EL2-bs of the second electrode EL2. As the separator SPR has the reverse tapered shape and is provided adjacent to the contact area, at least a portion of the contact area in which the second electrode EL2 contacts the connection electrode CNE may be disposed under the side surface TP of the separator SPR.

In an embodiment, at least a portion of the connection electrode CNE may be disposed under the separator SPR. The separator SPR may be disposed on the gap GP between the connection electrode CNE and the adjacent connection electrode CNEn adjacent to the connection electrode CNE, and the second edge EG2c of the second electrode EL2 may be covered by the separator SPR.

According to an embodiment of the present disclosure, the connection electrode CNE may have a shape to surround (e.g., around a periphery of) a portion of the emission area EA in which the light emitting element LD is disposed. Accordingly, the degrees of freedom may be improved at a connection position of the connection electrode CNE and the light emitting element LD, and a connection position of the connection electrode CNE and the pixel driver PDC. In addition, the top surface CNE-us of the connection electrode CNE may contact the bottom surface EL2-bs of the second electrode EL2 of the light emitting element LD through the contact area defined adjacent to the separator SPR. Accordingly, contact reliability of the connection electrode CNE and the second electrode EL2 may be improved, because the bottom surface of the connection electrode CNE contacts the top surface of the intermediate connection electrode CN. In the display panel DP according to an embodiment, the sizes of the through-holes OP-P and OP-60 for connecting the connection electrode CNE and the intermediate connection electrode CN may be reduced or minimized due to the above-described structure, and thus, the area or the resolution of the light-emitting part of the display panel DP may be improved (e.g., may be easily improved).

FIG. 10 is a cross-sectional view of a display panel DP-3 according to an embodiment of the present disclosure. FIG. 10 is a cross-sectional view showing a portion corresponding to the line II-II' in FIG. 4B. In FIG. 10, like reference numerals are used to denote like elements (e.g., the same or substantially the same elements) as those described above with reference to FIG. 5, and thus, redundant description thereof may not be repeated.

Referring to FIG. 10, the display panel DP-3 may further include the connection line CN-ad disposed between the sixth insulation layer 60 and the pixel definition layer PDL. The connection line CN-ad may be connected to the intermediate connection electrode CN through the through-hole OP-60 exposing at least a portion of the intermediate connection electrode CN.

In an embodiment of the present disclosure, the connection line CN-ad may be disposed at (e.g., in or on) the same layer as that of the first electrode EL1. For example, the connection line CN-ad may have the same material and same layer structure as those of the first electrode EL1. In addition, the connection line CN-ad may be provided in the same process as that of the first electrode EL1. However, the present disclosure is not limited thereto. For example, the connection line CN-ad may have a different material from that of the first electrode EL1, and may be provided in a different process from that of the first electrode EL1.

A through-hole OP-Pa may be defined in the pixel definition layer PDL. The through-hole OP-Pa and the through-hole OP-60 may not overlap with each other, but the present disclosure is not limited thereto. For example, in some embodiments, the through-hole OP-Pa and the through-hole OP-60 may overlap with each other. The connection electrode CNEa may be disposed in the through-hole OP-Pa. The connection electrode CNEa may be connected to a portion of the connection line CN-ad exposed by the through-hole OP-Pa.

According to some embodiments described above, the intermediate connection electrodes and/or the first electrode may extend to reduce or remove a coupling noise generated between the conductive patterns and the connection electrodes.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

## Claims

1. A display panel comprising:
a driving element layer comprising:
a first pixel driver comprising a first conductive pattern; and
a second pixel driver comprising a second conductive pattern;
a light emitting element on the driving element layer, and comprising a first electrode, an intermediate layer on the first electrode, and a second electrode on the intermediate layer;
a connection electrode on the driving element layer, and electrically connected with the first pixel driver and the second electrode; and
a metal layer between the second conductive pattern and the connection electrode in a cross-sectional view.

2. The display panel of claim 1, wherein the first conductive pattern comprises:
a (1-1)-th pattern; and
a (2-1)-th pattern electrically connected with the connection electrode.

3. The display panel of claim 2, wherein the second conductive pattern comprises a (1-2)-th pattern and a (2-2)-th pattern.

4. The display panel of claim 3, wherein the (1-2)-th pattern and the (2-2)-th pattern overlap with the metal layer in a plan view.

5. The display panel of claim 3 or claim 4, wherein the (1-2)-th pattern and the (2-2)-th pattern overlap with the connection electrode in a plan view.

6. The display panel of any one of claims 3 to 5, wherein the (1-1)-th pattern and the (1-2)-th pattern comprise source electrode patterns.

7. The display panel of any one of claims 3 to 6, wherein the (2-1)-th pattern and the (2-2)-th pattern comprise drain electrode patterns.

8. The display panel of any one of claims 1 to 7, further comprising:
an intermediate connection electrode electrically connecting the first pixel driver and the connection electrode to each other.

9. The display panel of claim 8, wherein the metal layer comprises a same material as that of the intermediate connection electrode, and is located at a same layer as that of the intermediate connection electrode.

10. The display panel of any one of claims 1 to 9, wherein the metal layer comprises a same material as that of the first electrode, and is connected to the first electrode.

11. The display panel of any one of claims 1 to 10, further comprising:
a pixel definition layer on the driving element layer, and having an emission opening therethrough exposing at least a portion of the first electrode,
wherein the connection electrode has a ring shape surrounding the emission opening.

12. The display panel of any one of claims 1 to 11, wherein a bottom surface of the second electrode contacts a top surface of the connection electrode.

13. The display panel of any one of claims 1 to 12, further comprising:
a separator on the connection electrode,
wherein the second electrode and the connection electrode are connected to each other at an area adjacent to the separator.

14. The display panel of claim 13, wherein the connection electrode comprises:
a first edge; and
a second edge surrounding the first edge and overlapping with the separator.
